# EUROPEAN PATENT SPECIFICATION

(11) **EP 2 681 749 B1**
(45) Date of publication and mention of the grant of the patent: **16.09.2020**
(21) Application number: 12715693.3
(22) Date of filing: 02.03.2012
(51) Int. Cl.: H01F 1/03

(54) **METHOD OF PRODUCING MAGNETIC SHAPE MEMORY ALLOY ELEMENTS**
HERSTELLUNGSVERFAHREN VON BAUTEILEN MAGNETISCHER FORMGEDÄCHTNISLEGIERUNG
MÉTHODE DE PRODUCTION D'ÉLÉMENTS D'ALLIAGE MAGNÉTIQUE À MÉMOIRE DE FORME

(30) Priority: 02.03.2011 FI 20115210; 02.03.2011 US 201161448213 P
(43) Date of publication of application: 08.01.2014
(73) Proprietor: ETO MAGNETIC GmbH, 78333 Stockach (DE)
(72) Inventor: EZER, Yossef, 00390 Helsinki (FI); SOROKA, Aleksandr, 00390 Helsinki (FI); STRAKA, Ladislav, 00390 Helsinki (FI)
(74) Representative: Patentanwälte Behrmann Wagner PartG mbB
(86) International application number: PCT/FI2012/050211
(87) International publication number: WO 2012/117164

(56) References cited:
- EP-A1- 1 961 830
- US-A1- 2009 241 537
- CHMIELUS M ET AL: "Effects of surface roughness and training on the twinning stress of Ni-Mn-Ga single crystals", ACTA MATERIALIA, ELSEVIER, OXFORD, GB, vol. 58, no. 11, 1 June 2010 (2010-06-01), pages 3952-3962, XP027045197, ISSN: 1359-6454 [retrieved on 2010-05-11] cited in the application
- J. BUSCHBECK ET AL.: "Epitaxial Fe-Pd magnetic shape memory films - Issues for preparation and applications", ACTUATOR 2008, 11 June 2008 (2008-06-11), pages 750-753, XP002678328,

## Description

### Background of the Invention

### Field of the Invention

The present invention relates to the magnetic shape memory (MSM) alloys. In particular, the present invention concerns a method of stabilization of mechanical and magneto-mechanical properties via stabilizization of the twin variant structure of objects (i.e. elements, specimens or samples) which comprise MSM alloys. Thus, the invention concerns a method which provides magnetic shape memory alloy elements with stabile mechanical and magneto - mechanical properties. The present invention also relates to the use of such a method for example in the form of an MSM device, such as an actuator, a sensor or an energy harvester, comprising an actuating element produced using the method.

### Description of Related Art

Magnetic shape memory (MSM) alloys are a class of materials capable of producing motion and or force or other related function. The essential feature of an MSM alloy is that it is capable of performing a martensitic transformation, wherein the higher-symmetry parental phase transforms to a lower-symmetry daughter phase, called martensite. MSM alloys differ from ordinary shape memory alloys in that the martensitic microstructure can be manipulated by exposing the alloys to a magnetic field.

MSM material consists of internal areas known as twin variants. These variants have different magnetic and crystallographic orientations. When an actuating element made of an MSM material is subjected to a magnetic field the proportions of the variants change resulting in a shape change of the element. Correspondingly, by mechanical deformation it is possible to change the magnetic state/properties of the MSM material e.g. permeability.

Early demonstrations of MSM effect on a Ni-Mn-Ga alloy revealed a strain of about 0.19 % [1]. Later, MSM materials exhibiting shape changes of up to 10 percent or more and response times of less than a millisecond have been developed.

In the following, the MSM effect and importance of twinning stress will be examined more closely.

First it can be pointed out that magnetic-field-induced rearrangement of (ferro-)magnetic twinned martensite microstructure, accompanied by a large macroscopic deformation, or magnetic shape memory effect, is a phenomenon which attracts attention since its first demonstration on Ni-Mn-Ga single crystal in 1996 [2]. Fast actuation seems to be one of the potential practical exploitations of the phenomena as magnetic shape memory effect with large strain up to 10% was already demonstrated many times starting from 1999 [3-10] and possibility of actuation in kHz range was also clearly shown [11]. Applications based on reverse mechanism were also suggested including sensing [12-14], energy harvesting [15, 16], damping [17], etc. Ni-Mn-Ga alloys have been so far most studied and can be considered as a "prototype" magnetic shape memory material.

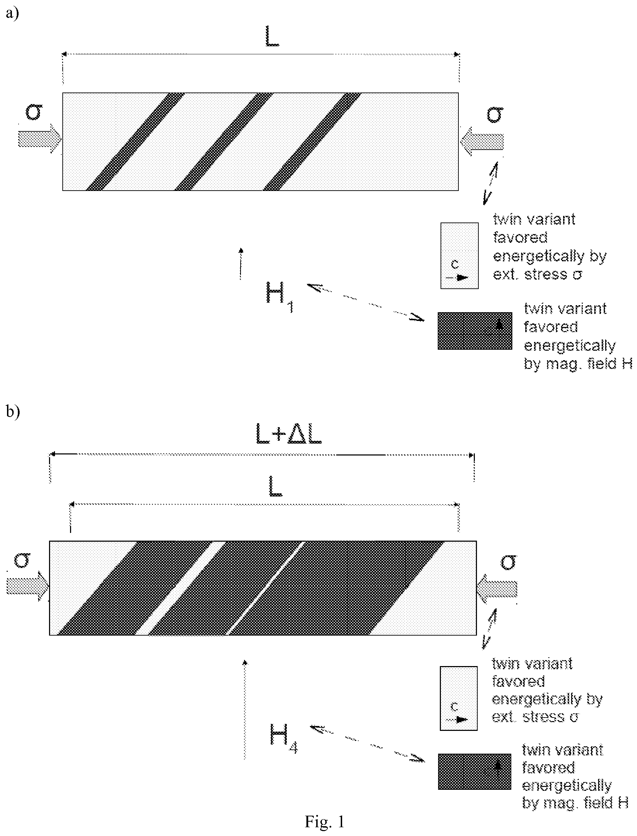

One way how to employ the MSM effect for linear reversible actuation is to apply a constant external stress σ along one principal axis and variable magnetic field H perpendicularly along another principal axis of a prismatic single crystal Ni-Mn-Ga MSM element, Fig. 1 [14, 18].

An overview of other possible arrangements can be found in reference [19].

The MSM element is typically cut along {100} faces and contains simple two-variant twin variant structure as this type of microstructure seems to exhibit the best performance [20]. One twin variant (light in Fig. 1) is favored energetically by the external stress while the other one is favored by the magnetic field. When the magnetic field is increased to a specific magnitude, the variant favored by magnetic field (dark) starts to grow at the expense of the variant favored by the stress (light). When the magnetic field is decreased, the reverse process takes place during which the external stress induces growth of twin variant favoured by the stress (light) on the expense of twin variant favored by the magnetic field (dark).

The c and a axis of the two discussed twin variants point along two different principal directions of the MSM element. Thus, by growth or consumption of one or other variant, the orientation of c axis inside the element is changed from one principal direction to the other principal direction. This is the reason why magnetic shape memory effect is sometimes called magnetic-field-induced reorientation, or MIR. The exchange of c axis for a axis or vice versa along certain directions in the MSM element results in large deformation of the element. The maximum possible linear strain is given by the difference between a and c axis, which is for example in 5M Ni-Mn-Ga martensite typically about 6%.

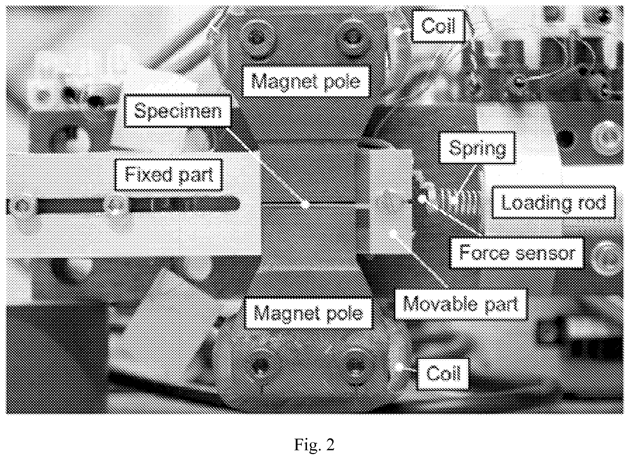

Slow (∼1 Hz) and quasistatic actuation by magnetic shape memory effect can be easily demonstrated and investigated using a simple magneto-mechanical apparatus as the one shown and described in Fig. 2. Using this simple apparatus with 20 mm long single crystals, MSM effect with strain close to 6% could be observed using naked eye. The same apparatus was used for determining the response of the studied crystals under compressive loading and in magnetic field. The twin variant structure, individual twin domains and twin variants were observed using polarized light optical microscopy. The microstructure was well observable by optical microscope from certain faces of the specimen even without polarized light. X-ray diffraction was an additional tool which we used to confirm observed or created twin configurations.

The mobility of twin boundaries is a crucial factor determining the existence, quality and efficiency of the MSM effect [5, 21]. The mobility of twin boundaries is in close relation with twinning stress, which can be experimentally evaluated from stress-strain curves of the material [22]. Twinning stress, aiw, is typically determined from the stress-strain curve as the level of applied compressive (or tensile) uniaxial stress which causes the twin boundary motion. More specifically, it is often determined as position of de-twinning plateau on stress-strain curve, or it can be determined as stress level at half deformation strain [20], or, two stress levels can be recorded - one near beginning and the second near the end of the stress-strain curve [5]. Such determination may not fully cover more general consideration of twinning stress for which the stress level at which twinning initiates (i.e., twin variants nucleate) must be distinguished from the stress level at which twin variants grow [22, 23]. This is discussed more below.

Lower twinning stress indicates higher mobility of twin boundaries. From the model of MSM effect introduced by Likhachev and Ullakko [5] it follows that to obtain reversible MSM effect, the twinning stress must be less than half of the magnetic stress [24], i.e. less than about 1.5 MPa as the maximum magnetic stress (OM) at room temperature is about 3 MPa (e.g. [24]). There is some general agreement that lower twinning stress result in better performance of MSM effect. How low below the above determined limit 1.5 MPa is satisfactory can be answered when considering the coupling factor, or efficiency of MSM effect determined as a ratio of obtained mechanical work and work spent on magnetizing of material during one magnetizing (actuating) cycle.

Table 1 [25] summarizes the calculated efficiencies for selected magnitudes of twinning stress using v = (σ_{M}-2σ_{TW})/σ_{M} [14, 21] and σ_{M} =3 MPa.

**Table 1. Efficiency example of MSMAs in spring-back-loaded magnetic actuator. Data for 5M Ni-Mn-Ga single crystal elements given as example. Applies naturally to all MSM-alloy systems if twinning stress of alloy is normalized to the magnetostress of that alloy.**

| Table 1. Efficiency of MSM effect *v* = (*σ_{M}*-2*σ_{TW}*)/*σ_{M}* determined using *σ_{M}* =3 MPa for selected levels of twinning stress *σ_{TW}*. | | |
|---|---|---|
| Twinning stress *σ_{TW}* (MPa) | Efficiency *v* % | Note |
| 10 | - | No MSM effect |
| 3 | - | Irreversible (one cycle) MSM effect |
| 1.5 | 0 | Reversible MSM effect |
| 1 | 33 | |
| 0.5 | 66 | |
| 0.2 | 87 | |
| 0.1 | 93 | |
| 0 | 100 | Ideal MSM material |

"Effects of surface roughness and training on the twinning stress of Ni-Mn-Ga singe crystals" in ACTA MATERIALIA, ELSEVIER, OXFORD GB, vol. 58, no. 11, 1 June 2010, pages 3952 - 3962, by M. Chmielus et al. discloses the effect of sample preparation differenced to the behavior of twin boundaries under the influence of external mechanical loads, i.e. the respective stress-strain-characteristics during external mechanical influence.

US 2009/241537 A1 describes a system for and method of harvesting, storing and converting naturally occurring energy, includes exposing an active material, and more preferably a shape memory element to an ambient activation signal or condition, harvesting a portion of the energy by pseudoplastically straining or superelastically deforming the element, storing the energy by causing a change in the element and/or engaging a locking mechanism, and converting the energy by exposing the mechanism to an activation signal and/or otherwise releasing the mechanism.

EP 1 961 830 A1 describes an iron-based alloy having shape memory properties and superelasticity, which has a composition comprising 25-35% by mass of Ni, 13-25% by mass of Co, 2-8% by mass of Al, and 1-20% by mass in total of at least one selected from the group consisting of 1-5% by mass of Ti, 2-10% by mass of Nb and 3-20% by mass of Ta, the balance being substantially Fe and inevitable impurities, and a recrystallization texture substantially comprising a y phase and a y' phase, particular crystal orientations of the y phase being aligned, and the difference between a reverse transformation-finishing temperature and a martensitic transformation-starting temperature being 100°C or less in the thermal hysteresis of martensitic transformation and reverse transformation.

### Effects of a twin variant structure on mechanical and magneto-mechanical properties of MSMAs

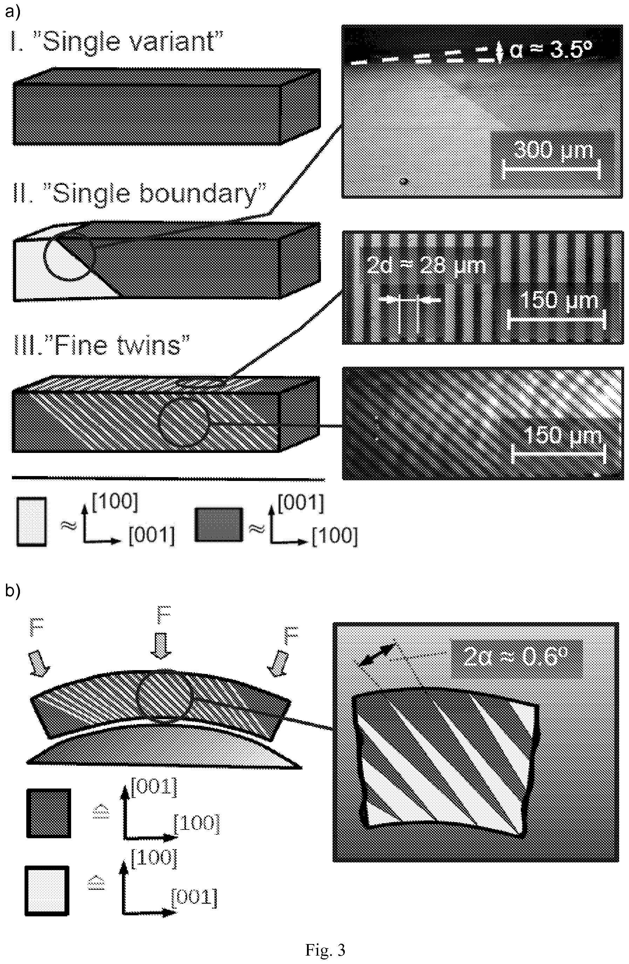

Additionally to the obstacles in the crystal, the twin variant structure also influences the twin boundary mobility (twinning stress) [27-29]. In other words, twin boundaries themselves can present obstacles for twin boundary motion [29]. Due to that the stress-strain response of the crystal depends on the twin variant structure, and, thus, attention must be paid to twin variant structure when determining the twinning stress or twin boundary mobility. We created well defined twin variant structures in the crystals using an external stress and / or magnetic field prior the testing. The morphology of the created twin variant structures is demonstrated in Fig. 3a. How microstructure with fine twins can be created by bending of single variant crystal [30] is illustrated in Fig. 3b.

Mechanical testing using compressive stress and measurement in quasistatic magnetic field under zero stress were performed for each microstructure presented in Fig. 3 using apparatus demonstrated in Fig. 2. For single variant, single twin boundary and for fine twins, magneto-mechanical testing under nonzero external stress was also performed. The results are shown and discussed below for each twin variant structure separately. Ni-Mn-Ga 5M martensite is used through the whole present document as the prototype alloy of MSMAs. Naturally, given considerations apply consistently for any MSM alloys, any martensite structures and any non-cubic lattice structures.

### Single variants and nucleation and motion of Single TB

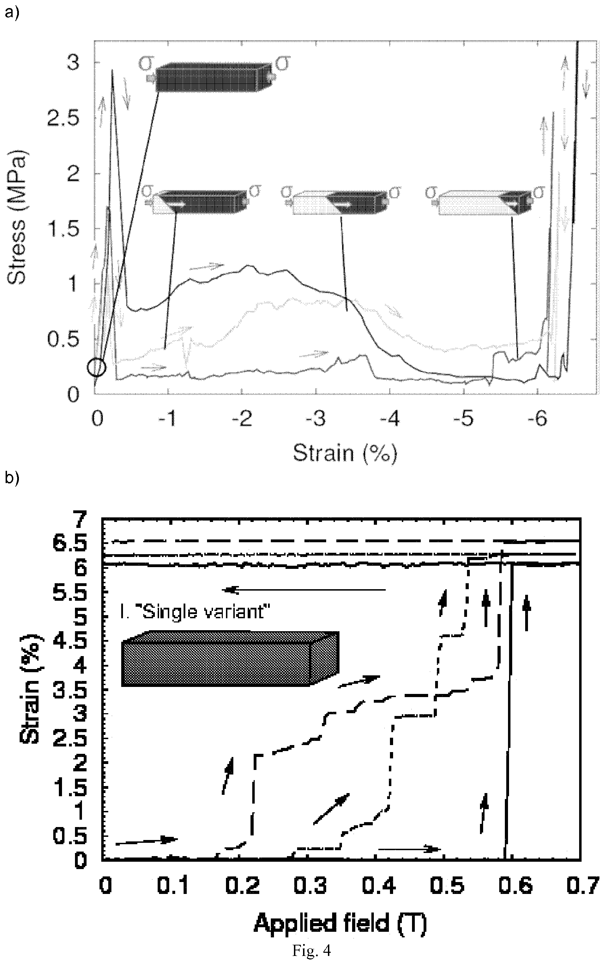

The main feature observed on stress-strain curves determined for single variant, i.e., for detwinned crystal, is large load drop at the beginning of loading by which initial stress peak was formed on the stress-strain curve, Fig. 4a). The load drop can be ascribed to the nucleation of new twin variant [22, 26, 27]. Note however, that in our experiment, we cannot recognize nucleation of twin domains on nm scale from growth of invisible, thinner than approx. 1 µm, residual twin domains. Nonetheless, for both cases the large height of the stress peak indicate existence of high nucleation barrier in Ni-Mn-Ga (detailed discussion on the topic was presented in [31]). High nucleation barrier is confirmed also by generally small amount of twin domains observed in Ni-Mn-Ga single crystals [32].

The height of the stress peak corresponds to the stress initiating twinning (nucleating new twin variants) in detwinned crystal (single variant) and, thus, we will refer to the height of the stress peak as initial twinning stress. The average height of the stress peak, or initial twinning stress, in our experiments was about 2 MPa.

After the twinning was initiated and some twin boundaries were clearly observed in the crystal, the deformation of the crystal progressed by motion of twin boundaries (with only occasional nucleation of additional twin domains). Stress required for this motion was much smaller (0.1-1 MPa) than initial twinning stress and we will refer to it as conventional twinning stress, or just twinning stress.

From the above it can be concluded that to achieve actuation with reasonable efficiency, some twin boundaries must be always present in the crystal. Otherwise, a high barrier (i.e., initial twinning stress) would have to be overcome by magnetic stress or by the external counterstress to achieve actuation. This was pointed out also in Ref. [31], where it was stated that the homogeneous magnetic field- induced nucleation of twin-boundaries is not likely which means that twin boundary motion in magnetic field may proceed only from preexisting twin boundaries, that are not detected macroscopically. Experiments in magnetic field confirmed that single variant very often showed no MSM effect at all, or showed but with limited strain. Note also that the initial twinning stress of 2 MPa is too high to allow reversible MSM effect in arrangement with external counterstress, Fig. 1.

The stress-strain curves varied considerably between individual experiments made on single variants. This was presumably due to different twin variant structure nucleated during each experiment. However, as demonstrated also in Fig. 4a), the stress necessary to move the twin boundaries often decreased to about 0.2 MPa. We concentrated on these cases, and after additional training of the crystal by repeated compression and extension we obtained crystals with single highly mobile twin boundary as described below. The magneto-mechanical response of an MSMA-specimen is strongly influenced by its mechanical response [5]. Consequently, larger stresses in the mechanical stress-strain curve (Fig. 4a)) indicate that a larger magnetic field is necessary for obtaining a magnetic field induced strain (Fig. 4b).

### Motion in Single Twin Boundary

The developed crystals showed tendency to nucleate only a pair or a few twin boundaries under compression and further deformation progressed by propagation of these nucleated twin boundaries [27]. The single twin boundary was formed from the nucleated pair when the pair was nucleated near end of a specimen and one boundary vanished at the end of the specimen. The remnant boundary showed high mobility either immediately or after a few compression-extension cycles performed manually in fingers while holding the crystal from its two ends.

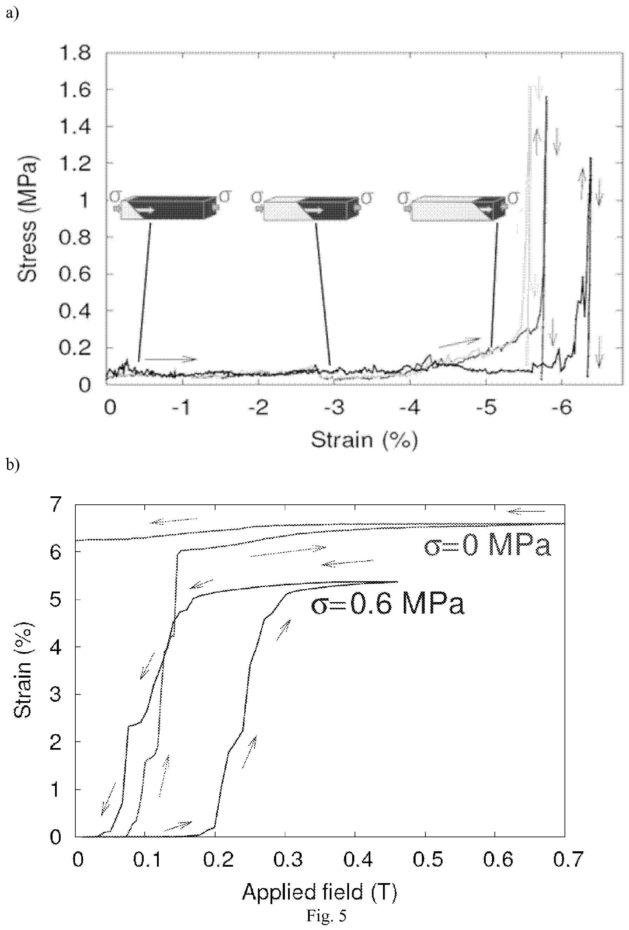

Compression tests of the crystal with single highly mobile twin boundary are demonstrated in Fig. 5a). The applied deformation (strain) induces motion of highly mobile twin boundary present in the crystal and, typically no other twin boundary appeared in the specimen until whole crystal had c-axis along the stress. At this point, the loading started to be elastic, which was indicated on the stress-strain curve by a sudden sharp increase of stress at the strain of about 6%. From the position of the de-twinning plateau on the stress-strain curve we determined that twinning stress of the crystal was about 0.1 MPa. This is considerably less than previously reported (e.g. 0.5 MPa in [33]).

The magnetic shape memory effect in the crystal with single highly mobile twin boundary in quasistatic magnetic field is demonstrated in Fig. 5b). The field-induced straining occurred at the applied fields of 0.12 T and 0.24 T (switching field) for the counterstress of 0 MPa and 0.6 MPa, respectively. This difference in switching fields was present due to that for 0 MPa applied stress only twinning stress had to be overcome by magnetic stress, but for 0.6 MPa applied stress the twinning stress and external stress had to be overcome by magnetic stress. This resulted in higher magnetic field needed for field induced straining of the crystal under load. In agreement with expectations, application of nonzero counterstress made the effect reversible as the specimen contracted along the applied stress when magnetic field was decreased.

Additional important factor influencing the switching field was the demagnetization factor of the crystal along the magnetizing direction. In the shown case, the field was applied perpendicular to 2.5x20 mm² face of the 2.5x20x1 mm³ specimen, thus, demagnetization factor was high. In spite of that, the observed switching field was rather low in agreement with the observed low twinning stress of the crystal. Magnetizing the crystal along direction with low demagnetization revealed that applied field as low as 0.03 T (300 Oe) was enough to achieve the MSM effect [34].

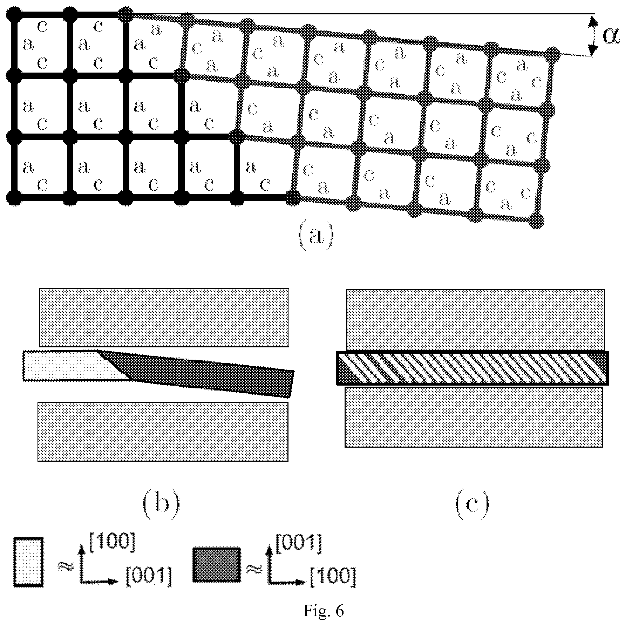

The low twinning stress determined from stress-strain curves and demonstrated high mobility of twin boundaries in magnetic field together with more detailed investigations (using tensile stress [27] and different temperatures clearly confirm that it is possible to achieve very high mobility of twin boundaries in Ni-Mn-Ga. However, the crystal with single twin boundary does not seem to be the best candidate for practical usage in a magnetic actuator with a narrow air gap. One of the problems is demonstrated in Fig. 6. In Figure 6 a-b) geometrical problem connected to the motion of single twin boundary is, that it requires more space than is the thickness of the element, and if space is not enough, then the motion of TB is blocked and element does not work. In Fig. 6c) the problem of geometry restrictions can be solved, for example by introduction of fine twin variant structure into the MSMA-element. The 3-4 deg kink of the specimen on the twin boundary present due to twinning crystallography (Fig. 6a-b)) creates geometrical problem in a tight air gap. Sample stuck easily in such air gaps which prevents any strain or force output. The specimen with only one twin boundary may also be difficult to handle in a real-life application such as magnetic actuator with a narrow air gap for example, Fig. 6a-b).

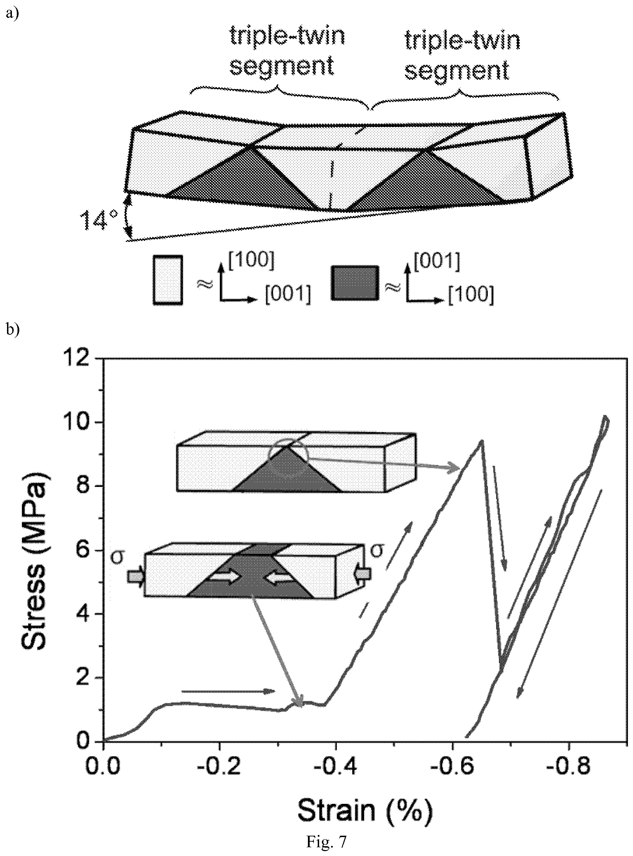

The stochastic nature of single twin boundary motion [35] and slower response of crystals with small number of boundaries [31] may be listed as other reasons why to consider twin structure with many twin boundaries or fine twins as in Fig. 6c). Also in sample with single twin boundary, hard single-domain triple-twin segments can appear (see Fig. 7a)), which create strong obstacle to the twin boundary motion, up to 10MPa (see Fig. 7b) that blocks the MSM effect completely. This can induce high local stresses on microscale which often leads to crack nucleation.

Additionally, handling the large untwinned volume of the crystal may not be trivial as in this volume any orientation of twins can appear. These can interfere with existing boundaries and hinder their motion. The above mentioned reasons initiated the effort to create fine twin structure in the material and to employ it in actuation, which is described in more detail below.

### Fine twins

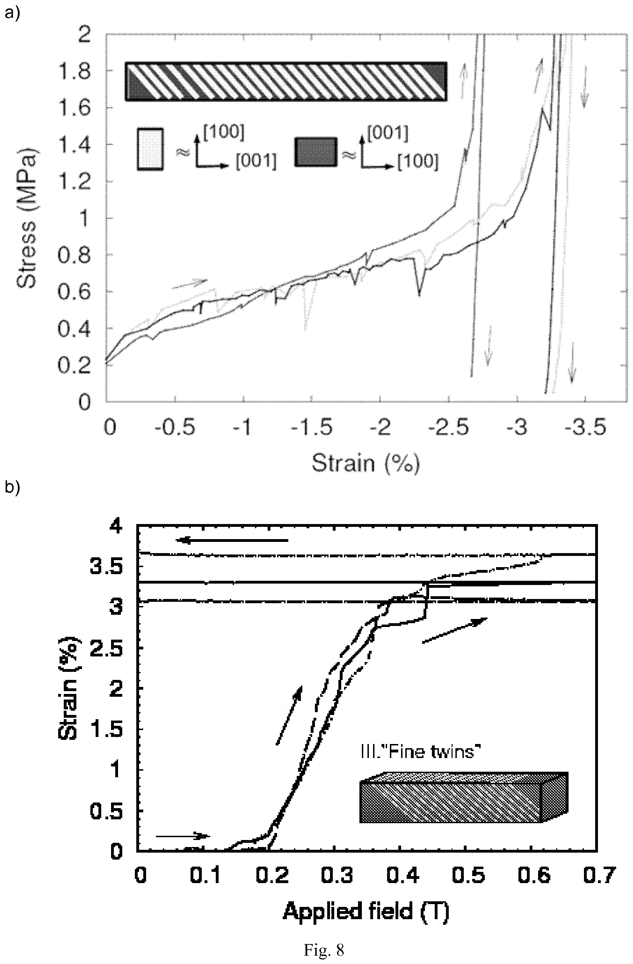

Fine twins, also called parallel lamellar twins or polysynthetic lamellar twins with density about 10 - 100 boundaries/mm, can be created in the crystals by bending [30], Fig. 3b). The mechanical testing of specimen with fine twins revealed that this type of microstructure exhibited about one order higher twinning stress, i.e. about 0.8 MPa, Fig. 8a) than the above described case with single twin boundary. The reason for this increase is under investigation. The response in magnetic field under zero counter-stress, Fig 8b), corresponded to the observed stress-strain curves. Higher twinning stress resulted in higher magnetic field necessary to induce the MSM effect.

A remarkable benefit of the "Fine twins" is that in sample having such twin variant structure the deformation cannot occur by single twin boundary motion. There is still a three to four degrees kink of the sample at each twin boundary, but since the distance between boundaries is small and the neighbor kinks are of opposite sign, they cancel out each other on macroscopic scale. The absence of one or few large parts with this kind of kink removes the geometrical problem shown in Fig. 6. Thus the element with fine twins does not stack in tight air gap of an MSM device, for example an actuator or sensor or energy harvester. However the non-stabilized fine twins disappear already after one or few elongation-compression cycles after which the element deforms again by one or few twin boundaries, after which the element can enter the highly undesired single variant state or form any other undesired twin configuration, for example such as shown in Fig. 7.

The fine twins are annihilated completely from the crystal by compression of several MPa stress or by high magnetic field. Thus, achieving reversible MSM effect in the crystal with non-stabilized fine twins is not possible since the twins annihilate each other.

The sample with a fine twin variant structure showed a considerably higher twinning stress than the sample with a highly mobile single twin boundary, compare Fig. 5a) and Fig. 8a. In spite of the higher twinning stress, the fine twin variant structure exhibits several advantages. For example, mechanical properties (e.g. proportional mechanical and magneto-mechanical properties which can be seen in Fig. 8a-b), as a positive slope and relatively smooth stress-strain curve profile. The same advantages apply to magneto mechanical properties which can be seen as proportional magnetic field induced strain in Fig. 8b), there are no problems with sample geometry if the twin bands are fine enough and the fatigue life should be much longer for fine twins than for other microstructures in case that they could be stabilized [37].

### "Dispersed triple-twin segments" twin variant structure

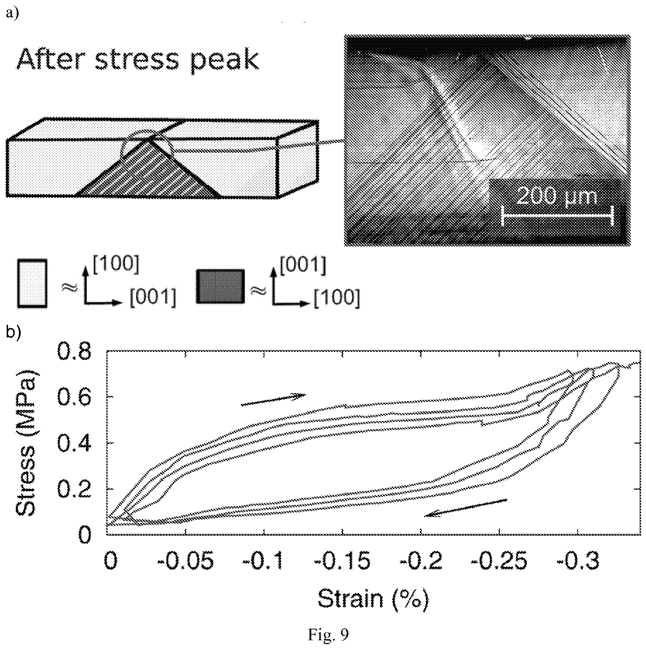

The twins that are nucleated inside the central twin domains (dark) of triple-twin segments are rather thin (∼ 1-10 µm or less; see below) and they end at a twin boundary as shown in Fig. 9a). As discussed in [36] and in Ref. [17] thin twins ending at an interface can exhibit rubberlike elasticity or magneto elasticity due to their inherently reversible motion. The proposed mechanism of the effect based on the repulsive interaction of the twinning dislocations is described in Refs. [17, 24, 39]. The twin boundary perpendicular to the fine twins acts as the interface. The twinning dislocation(s) of the fine twins blocked at the interface strongly repels the gliding twinning dislocations of fine twins pushed toward the interface by the external stress or by magnetic field. Hence, under a reasonable external load, the gliding twinning dislocations will pile up near the interface (fine twins will broaden) but will not enter it. Due to the repulsive interaction between the dislocations, the gliding dislocations will regress and return to their initial positions when the load is removed (fine twins will have their original size). Thus, the motion of the twin boundaries of fine twins ending at a twin boundary can be self-reversible. Adding up the same effect from many fine twin domains will result in a considerable macroscopic deformation under load and the recovery of the original shape when the load is removed.

By performing several compression tests with many carefully performed partial cycles we, indeed, detected a significant recoverable deformation in a specimen with fine twin domains ending at a twin boundary. The magnitude of the recoverable strain varied in different experiments. It presumably depended on the exact morphology of the twins nucleated during each experiment. Loading curves as in Fig. 9b) represent the largest effect observed with the recoverable strain of about 0.3%. With different twin variant structures (single twin boundary or fine twins not ending at a twin boundary), the same material showed only pseudoplasticity or magnetoplasticity with a negligible recoverable strain [15, 16].

The stress plateaus associated with the recoverable deformation were at the level of about 0.5 MPa as shown in Fig. 9b). This is much lower than the maximum magnetic driving stress, which is about 3 MPa at room temperature for 5M martensite [21, 37, 38].

Therefore, by applying the equivalence of the mechanical stress and the magnetic stress [5, 19, 38], it should be possible to achieve a similar loading path as presented in Fig. 9b) by the application of a magnetic field to the specimen instead of stress. Thus, the magnetoelastic response of 0.3% should be obtained in the specimens by careful partial magnetizing cycles.

The microscopic observations we made were in agreement with the mechanism of magnetoelasticity based on the repulsive interaction of twinning dislocations described above. Under stress, the thin twins were much thinner near the perpendicular twin boundary at which they ended and much wider far from the boundary. This confirms that the twinning dislocations experienced difficulties in gliding past the twin boundary and, thus, piled up near the twin boundary instead. The typical observed thicknesses of the twins were -1-10 µm far from the boundary and ∼1 µm near the boundary (or much less, since some twins became invisible in an optical microscope when they were traced from the region far from the twin boundary toward the twin boundary).

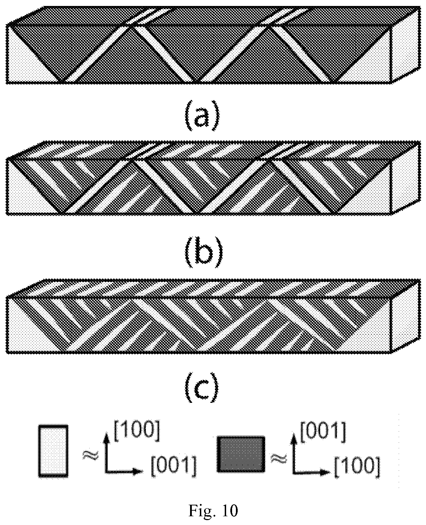

The estimation based on the assumption that the recoverable strain is proportional to the volume occupied by the active region gives the estimated maximum macroscopic recoverable strain of 2.5% for active regions occupying 100% of the specimen volume. Various microstructures with an active region occupying a large volume of the specimen can be designed. One possible design based on triple-twin segments is shown in Fig. 10.

In connection with the present technology, the existence of triple twins in Ni-Mn-Ga magnetic shape memory single crystals with modulated five-layered martensite has been experimentally demonstrated. The single-domain triple twins or triple-twin segments (see Fig. 7 a-b)) hinder the microstructure rearrangement, but can be transformed by moderate loading (order of 1-10 MPa) to a more complex twin variant structure (dispersed triple-twin segment) with rubberlike elastic behavior (see Fig. 10 a-b). Based on the observations it can be estimated that rubberlike elasticity and magnetoelasticity with up to 2.5% macroscopic recoverable strain can be achieved by microstructure modification in initially pseudoplastic (magnetoplastic) specimens. Thus, it seems that one can adjust the mechanical and magnetomechanical response of the material very significantly by microstructure tailoring.

### Conclusions on different twin variant structures

Single-variant problems; On the measurements demonstrated above we showed that it is necessary to distinguish between initial twinning stress, i.e., stress nucleating a twin boundary/boundaries or initiating twinning in material and conventional twinning stress or just twinning stress, i.e., the stress inducing motion of existing twin boundaries. As the former seems to be typically much higher than the latter, and additionally it was shown that single variant shows a hardly predictable magneto -mechanical response and sometimes no response at all, the state of specimen without twin boundaries (i.e. single variant or detwinned specimen) should be avoided completely during exploitation of the material in real applications: actuation, energy harvesting, sensing, etc.

Single twin boundary problems: Even the specimen with pre-existing twin boundary or few separate twin boundaries contains several serious problems. For a single twin boundary, a sharp kink (by 3.5 degrees in 5M Ni-Mn-Ga, in other martensite structures, like 7M and NM, can be even higher) of the whole sample on the twin boundary causes geometrical problems in using the sample in a typical magnetic actuator and other space limited applications. Additional problems are related to the fact that single twin boundary can easily annihilate at the end of the sample or when meeting another twin boundary with same orientation after which the sample becomes a single variant [27]

Also, in contrast with an all-time-monitored bench-top experiment in laboratory environment, it is not easy to assure that more complex microstructures are not nucleated in the single variant sample or sample with single twin boundary during its use in real-life applications. Such unpredictable twin variant structures with an undesired twin configuration can show a higher twinning stress and need a higher magnetic field to achieve actuation and/or may easily lead to fast fatigue failure and braking of the MSM-element. As a result, the performance of an MSM-element (actuating, harvesting, sensing, mechanical, structural, etc.) is strongly degraded and/or unpredictable.

Problems of non-stabilized "Fine twins": Our experiments demonstrate that a MSMA specimen can be turned easily, e.g. by bending, to a specimen with fine twins exhibiting moderate twinning stress and proportional MSM effect. In spite of the higher twinning stress, the fine twin variant structure exhibits several advantages. For example, there are no problems with sample geometry if the twin bands are fine enough. Additionally other undesired twin variant structures cannot appear in specimen with fine twin variant structure since the whole volume of specimen is already occupied by parallel twin boundaries and there is no large single- variant parts of volume where unwanted twin configurations could nucleate. Even if in specimen comprising of fine twins some undesired twin configurations do nucleate, they will be small in size and considerably less harmful than large unwanted twin configurations that can appear in single variant or single twin boundary specimen.

However, after few elongation-compression cycles by the action of external stress or magnetic field, the twin boundaries comprising the fine twin variant structure annihilate, which leads in a rapid decrease in the density of twin boundaries. Thus, very soon the sample contains only few twin boundaries, approaching and typically reaching the single twin boundary case, or sample goes in single variant state and in both cases behavior of the sample becomes again unstable or unpredictable as described above. Unintentional deformation of the specimen into single variant state is very typical for MSM alloys specimens and can block/prevent the MSM effect completely as discussed above.

Problems of non-stabilized "Dispersed triple-twin segments" as well as of other non-stabilized complex twin variant structures: The "dispersed triple-twin segment" micro structure has same benefits as fine twin variant structure except that it has shown to possess additionally some amount of pseudoelasticity (magneto elasticity), also similar non-stability arguments apply for Dispersed triple-twin segments.

The dispersed triple-twin segment structure has been shown to posses weak stability under very limited conditions which is however far insufficient for the real industrial applications.

Based on the above, it appears that any artificially created twin variant structure introduced in MSMA-element after the crystal-growth is very likely to be not stable enough for real-life industrial applications without additional stabilization modification/treatment.

It was demonstrated above that the twin variant structure of a magnetic shape memory alloy strongly influences on its mechanical and magneto -mechanical response. Conversely, by tailoring the twin variant structure, one can obtain rather different mechanical and/or magneto -mechanical responses of the material, which can be exploited in adjusting the actuating, energy harvesting, sensing and structural properties of MSM alloys.

Twin variant structures can posses inherently either instability, or unpredictable behavior accompanied with instability, in mechanical and magneto -mechanical response. The significant effect of twin variant structure on the mechanical and magneto -mechanical response of MSMAs was demonstrated by using 5M Ni-Mn-Ga single crystal elements as an example, but naturally the effect can apply on any MSM-alloy system (stoichiometric, non-stoichiometric, or with alloying additions like Fe, Co, Cr, Cu, Ti, Zr, Al, Mo, W, for example and any combination thereof) and any martensite structure (5M, 7M, NM, etc.) and any lattice structure (tetragonal, orthorhombic, monoclinic, triclinic, etc.).

For proper utilization of different twin variant structures (for example such as "Fine twins" or "Dispersed triple-twin segments") accompanied with their different mechanical and/or magneto-mechanical properties, there is a need for finding ways of making such twin variant structures stable (to prevent their transformation to other (undesired) twin variant structures) in real out-of- laboratory application environments, such as actuator, energy-harvester, sensor applications for example. Any such technical solutions should be implementable on an industrial production scale also.

Thus, keeping the above introduced twin variant structure and resulting performance instability issues in mind, the present invention aims at providing solutions for stabilization of different twin variant structures, in particular (but not only) the tailor-made structure of "Fine twins" and of "Dispersed triple-twin segments", which result in stable and easy to use MSMA-elements for various applications such as actuators, sensors, energy harvesters or any other MSM-device.

For stabilization or creation and stabilization of twin variant structures a novel solution involving functional twin-affecting surface modification has been provide. The present technology stands for the previously missing step for large scale production of MSMA-elements with properties selected from the group of stable, repeatable, tailored, designed, desired mechanical and magneto-mechanical properties and any combinations thereof.

### Summary of the Invention

It is an aim of the present invention to eliminate at least a part of the problems related to the known art and to provide a new method of modifying MSM materials toward having a predictable and repeatable mechanical and magneto-mechanical response.

It is a particular aim of the present invention to provide a method by which it is possible to create a stable fine twin variant structure in single crystal MSM-samples. It was found in the present invention according to claim 1, that one or more of the above mentioned problems can be solved by a method of modifying an element of a magnetic shape memory alloy being a composition of Ni, Mn and Ga, with an optional addition of at least one element selected from the group of Cr, Co, Cu, Fe, Ti, Al, In, Zr, Mo, Ta, W, V, Nb, Y and Pd and comprising a microstructure of twin variants and having a surface, said method comprising the step of modifying the surface layer of the element to activate and stabilize the twin variant structure of the element, wherein the surface modification is carried out on at least two opposite surfaces of the element, wherein said surface layer or surface region comprising less than 20 %, preferably less than 5 %, advantageously less than 1% at the most of the total thickness of the element at the site of the treatment and characterized in that the surface modification is carried out by surface bombardment and/or the surface treatment is carried out by Shot-Peening using Glass-beads, such as spherical glass-beads, said treatment preferably being carried out for a sample having a thickness at the treated portion of 1mm or more. Other aspects of the present technology are disclosed in the dependent claims.

The present invention provides considerable advantages:
The mechanical or magneto-mechanical response of an MSM element can be adjusted according to the need and application of the element. The mechanical and mageneto-mechanical response can be made more repeatable that in a conventional MSM material.

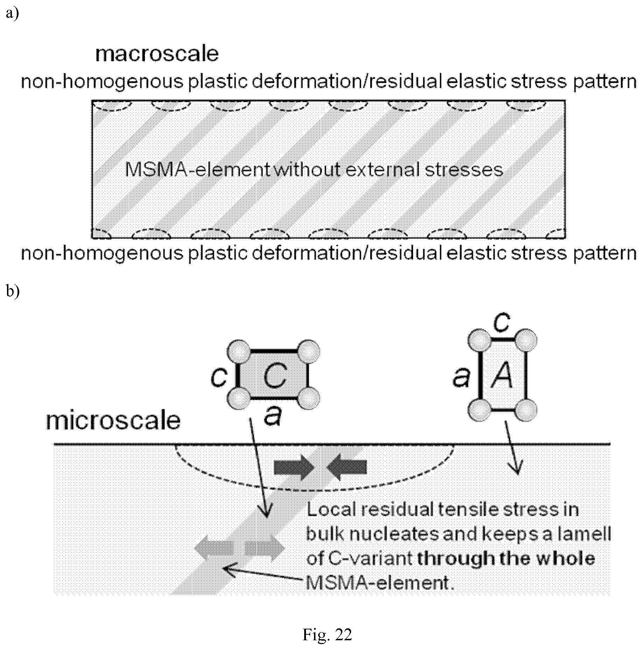

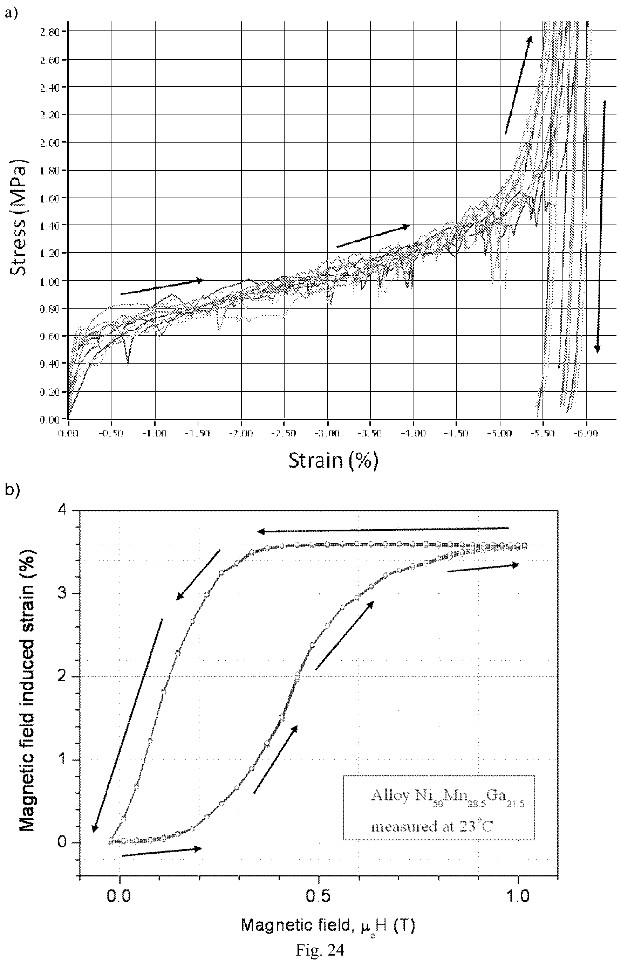

Such elements show a mechanical response as shown in Fig. 22 which never stays in single variant state under stress-free state. Thus, apart from the relatively high twinning stress, this material seems to be optimal for using in an actuator and typically exhibits a stable mechanical and magneto-mechanical response. This was confirmed by measurements in the experimental device presented in Fig. 2 and in the magnetic actuator. The developed single crystal samples with a stable fine twin variant structure show an excellently repeatable magneto-mechanical response of about 3% in the presented experimental apparatus, Fig. 24b and in an actuator. This is in contrast with the non-stabilized specimens with coarser twins or single twin boundary, which show such a long fatigue life only very occasionally. The response of a MSM-specimen can also be tailored according to the needs, for example slope (proportionality) of the stress-strain curve and level of twinning stress (damping capacity) can be adjusted by selecting suitable surface treatment process parameters. The main advantages of the developed technology are, for example:
- The twin variant structure in surface treated MSM-specimens is considerably more stable than in non-treated MSM-specimens.
- By the developed method of stabilization of desired twin variant structure it is possible to stabilize and adjust the mechanical and magneto-mechanical properties of MSM elements.

The technology now presented for functional twin- affecting surface modification on MSM materials comprises two general embodiments, one involving twin-stabilizing surface modification and the other twin-activating surface modification. These will be described in detail in the following.

### Brief Description of the Drawings

Fig. 1 Reversible several percent actuation of a crystal showing magnetic shape memory (MSM) effect can be achieved by the combined application of magnetic field and external stress, a) In zero or small magnetic field H₁, the twin variant favored by the applied external stress σ (initial variant, light) occupies most of the crystal volume, b) With increasing magnetic field, the twin variant favored by magnetic field (dark) grows on the expense of the initial variant, which is accompanied by a several percent deformation at final field H₄. When the field is decreased back to zero or H₁, the twin variant structure rearranges to initial state shown in (a) due to the effect of external stress which favors the initial (light) variant.
Fig. 2 Apparatus used in this study for the investigation of MSM effect and of mechanical properties. Magnetic field and compressive stress were applied perpendicularly. Spring was not installed during compression tests but it was installed for measurement of magnetic- field-induced strain. Applied magnetic field was determined without specimen installed by a hall probe not shown in the figure.
Fig. 3 a) Twin variant structures investigated in this study: i) single variant, ii) single boundary iii) fine twins. Fig. 3 b) Illustration how fine twins can be created by bending of a single variant sample.
Fig. 4 a) Response of single variant (de-twinned crystal) to compressive stress. The three displayed measurements were performed on three different single variant crystals. Observe 1-3 MPa stress peak connected to twin boundary nucleation in single variant specimen. Fig. 4 b) Magneto-mechanical response of the studied samples under near zero counter-stress showing magnetic-field induced strain (MFIS). Three representative measurements performed on the same specimen, starting each time from single variant state.
Fig. 5 a) Response of crystal with single highly mobile twin boundary to compressive stress. Fig. 5 b) Response (MFIS) of crystal with single highly mobile twin boundary to magnetic field for external stress 0 and 0.6 MPa (marked next to curves). All displayed measurements were performed on the same crystal.
Fig. 6 a) Due to twinning crystallography, a tilt of 90-2arctan(c/a) is present at each twin boundary. Fig. 6 b) This causes typically problems when using specimen with a single (or few) twin boundaries in an actuator with a narrow air gap. Fig. 6 c) Creating dense fine twins into the specimen eliminates the problem.
Fig. 7 a) Two identical single-domain triple-twin segments. Five twin domains show five different orientations and the tilt between the ends of the specimen is 4α=14°. Dark triangles are the central domains of each segment. [36]. Fig. 7 b) Response of specimen with one single-domain triple-twin segment, such as shown in Fig. 8a), to compressive stress. Observe almost 10MPa peak around 0.6% strain showing high resistance to deformation of that twin configuration. [36]
Fig 8 a) Response of fine twins to compressive stress (determined on the same crystal as in Fig. 5) Fig. 8 b) Response (MFIS) of fine twins to applied magnetic field under zero counterstress.
Fig. 9 a) Schematic and optical microscope image of twin variant structure called "Dispersed triple-twin segment". The shown twin variant structure exhibited the mechanical behavior as shown in Fig. 9 b) on the right. The details of creation of such twin variant structure are described in [36]. b) Large recoverable strain (rubberlike elasticity) observed during the compression of a specimen with fine twins ending at a perpendicular twin boundary (dispersed triple-twin segment), see Fig. 10 a). Three subsequent loops demonstrate reasonable repeatability and stability of the effect under small stresses (lower than 1-1.5MPa). Continuing loading gradually transforms the fine twins of the dispersed triple-twin segment to a single martensite variant (detwinned single crystal) with [001] along the stress axis. [36].
Fig. 10 The illustration of a possible design of a twin variant structure with large recoverable strain (large rubberlike elasticity and magneto elasticity). Fig. 10 a) The design can begin with the multiple-twin variant structure consisting of many densely packed triple-twin segments (see also Fig. 3). Fig. 10 b) Large recoverable strain can be achieved by creating fine twins ending at the twin boundary in all central twin domains of triple-twin segments [see Fig. 4 and Fig.5]. (c) The final designed twin variant structure is obtained after considering that the twin domains positioned originally between the triple-twin segments can be made very thin and can also participate in the recoverable straining. [36]
Fig. 11 Lamellar unidirectional fine twin variant structure LUFTVS created according to Fig. 3b, prior to surface modification.
Fig. 12 Optical microscope image of the twin variant structure called LUFTVS (called also "fine twins"). The non-stabilized twin variants are seen as light and dark stripes approximately at 45 degrees. The twin variants are separated by twin boundaries. The shown twin variant structure is exactly same as the "fine twins" introduced in Ch.3.3.
Fig. 13 Definition of surface layer and bulk in case of rectangular shaped MSM element.
Fig. 14 Demonstration of surface layer bombardment process for element with prior made tailored twin variant structure (LUFTVS).
Fig. 15 Schematic figure of the LUFTVS twin variant structure stabilized by the developed method Cold Shot-Peening, CSP including the assumed plastic deformation pattern.
Fig. 16 Optical microscope image of the LUFTVS twin variant structure stabilized by the developed method Cold Shot-Peening, CSP.
Fig. 17 a) local plastic deformation (by dislocations) of C-variant and local transformation (by twinning) of A-variant into the C-variant. Fig. 17 b) Transformation from one twin variant to another by twinning is reversible, instead the plastic deformation by dislocations is irreversible.
Fig. 18 a) The non-homogenous plastic deformation/residual elastic stress pattern does not disappear even if the element is forcefully elongated to single variant state. Fig. 18 b) The supposed/expected residual stresses originating from Twin-stabilizing surface modification are shown schematically on microscopic level
Fig. 19 Schematic figure of the LUFTVS twin variant structure stabilized recovers automatically even after elongating to single variant state as shown in Fig 18.
Fig. 20 The reason for spatially selective nucleation event is thought to be due to relatively strong residual elastic stresses (shear stress or compressive stress) exactly on the place of "old" twin boundary between A-variant and C-variant that existed on that place during surface treatment (here bombardment).
Fig 21 a) The non-homogenous plastic deformation/residual elastic stress pattern does not disappear even if the element is forcefully compressed to single variant state. Fig. 21 b) The supposed/expected residual stresses originating from Twin-stabilizing surface modification are shown schematically on microscopic level
Fig. 22 a) Schematic figure of the LUFTVS twin variant structure stabilized recovers automatically even after compression to single variant state as shown in Fig 21. Fig. 22 b) Preferred nucleation site of C variant lamellas after the elements has been deformed to compressed single variant state.
Fig. 23 Stress-strain curves demonstrating unstable/stochastic behavior of non-stabilized MSMA-elements (5M Ni-Mn-Ga) manufactured by previous art technology.
Fig. 24 a) Stress-strain curves of three different 5M Ni-Mn-Ga specimens (Same 5M Ni-Mn-Ga MSM-material and same specimens as in Fig. 23) but now with stabilized fine twins (LUFTVS), stabilized by the developed *Twin-stabilizing surface modification (CSP).* Fig. 24 b) Curve family showing 10 cycles of MFIS of the specimen with stabilized fine twins demonstrating excellent repeatability between cycles and proportional behavior. Material after same surface treatment as in Fig. 24.
Fig. 25 a) Effect of pressure of incoming jet of particles during bombardment process (method CSP, method modification CGSP) on the profile of stress-strain curve of the specimen. Fig. 25 b) Shown are pseudoelastic parts of the stress strain curves of the same samples as in fig. 25 a.
Fig. 26 Shows an MSM element in austenitic state (cubic lattice, no twins).
Fig. 27 Shows schematically twin activating surface modification process.
Fig. 28 a) Plastic deformation of the whole surface layer (by dislocations).

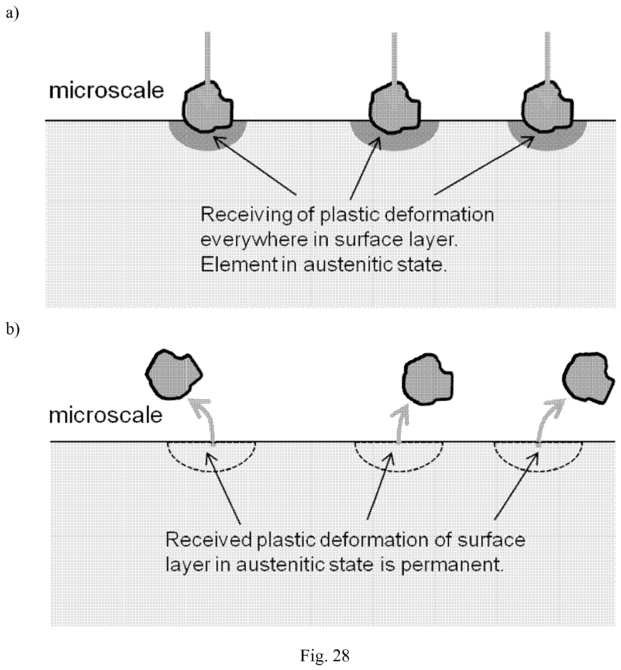

Fig. 28 b) Plastic deformation in austenitic state by dislocations is permanent.

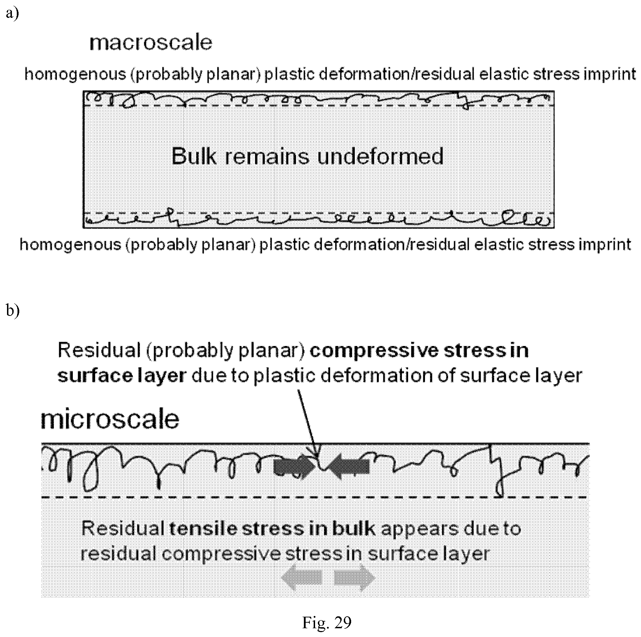

Fig. 29 a) Demonstrate the permanent plastic deformation and possible residual elastic stress imprint in surface layer of MSM element in austenitic state. Fig. 29 b) The supposed/expected residual stresses originating from Twin-activating surface modification are shown schematically on microscopic level

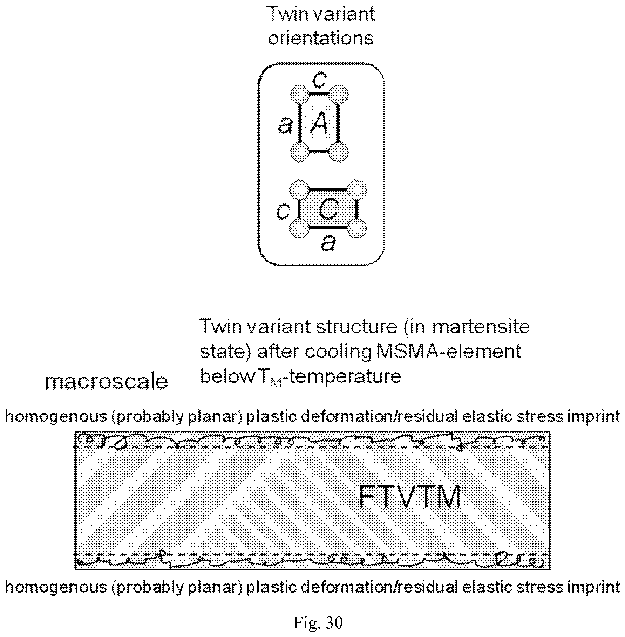

Fig. 30 Schematic figure of MSMA-element after Twin-activating surface modification shown the activated and stabilized fine two-variant structure FTVS.

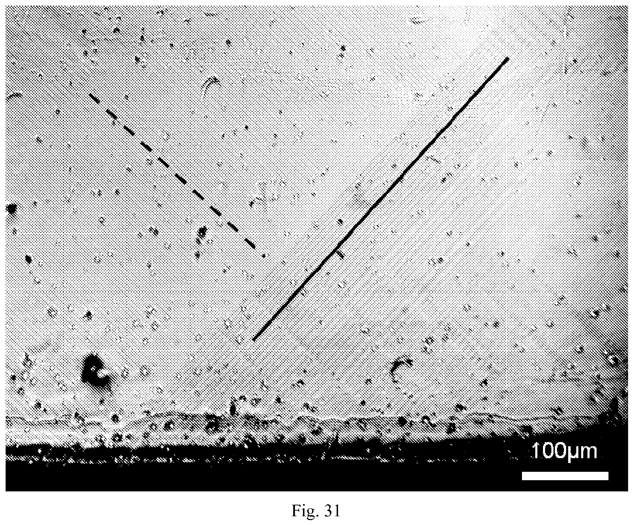

Fig. 31 a) Twin activated MSM element forcefully elongated to single variant state.
Fig. 31 b) Twin activated MSM element forcefully compressed to single variant state.

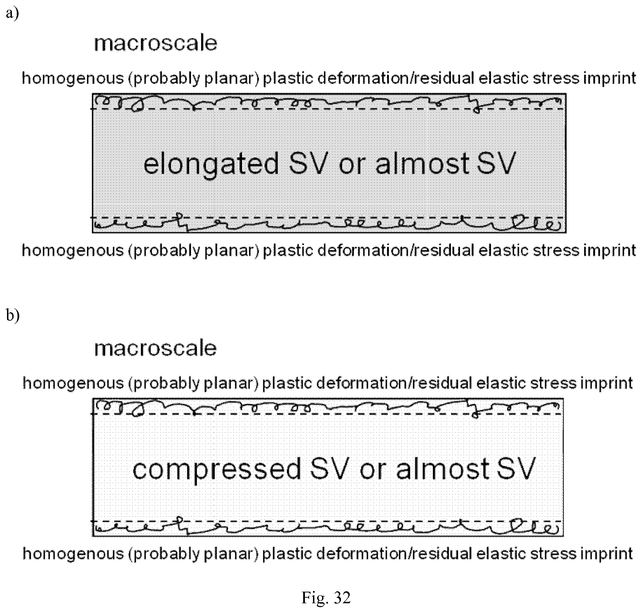

Fig. 32 Optical microscope image of MSMA-element after Twin-activating surface modification shown the activated and stabilized fine two-variant structure FTVS. The continuous and dashed lines show the two stabilized twin boundary orientations. Shown twin variant structure is based on the "Dispersed triple-twin segments".

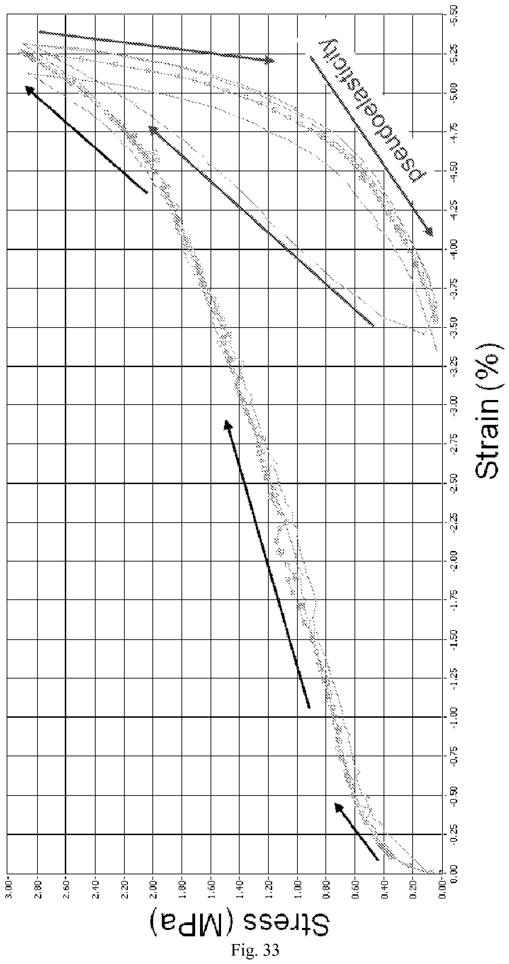

Fig. 33 Stress-strain curves of one 5M Ni-Mn-Ga specimen with stabilized non-parallel fine twins (FTVS), activated and stabilized by the developed Twin-activating surface modification (HSP).

### Detailed Description of Preferred Embodiments

For stabilization or creation or activation and stabilization of the (desired tailored, designed) or any twin variant structures various embodiments are provided which allow for the production on a large scale of MSMA-elements with properties selected from the non-limiting group of stable, repeatable, desired mechanical and magneto-mechanical properties and combinations thereof.

### Definitions

For the purpose of the present invention, the term "element" will be used interchangeably with "object" and "specimen" or "sample" to designate any item formed by an MSM-alloy of interest which has properties of super- or pseudoelasticity, magnetoelasticity or magnetic shape memory.

The "MSM alloy" according to the present invention generally refers to any MSM-alloy system of the above kind and others which are defined below. The term thus includes stoichiometric and non-stoichiometric alloys which is primarily formed by specific metals, such as Ni, Mn and Ga, with optional alloying additions, like Fe, Co, Cr, Cu, Ti, Zr, Al, Mo, W, for example and any combination thereof). All martensite structures (5M, 7M, NM, etc.) and lattice structures (tetragonal, orthorhombic, monoclinic, triclinic, etc.) are similarly included.

In one example, the present technology comprises surface treatment of MSMA-element(s) aiming at obtaining, stabilizing or combinations thereof of selected twin variant structure and optionally purposefully to affect mobility (twinning stress) of twin boundaries. This embodiment is also referred to as *Functional twin-affecting surface modification.*

In one embodiment, surface treatment of MSMA-element is carried out on a tailored twin variant structure, i.e. an MSMA element in martensite state. This embodiment is also referred to as *Twin-stabilizing surface modification.*

In another example cold (e.g. ambient temperature, generally lower than the martensite transformation temperature) Shot-Peening, CSP. Shot-peening by small particles. Shot-peening is carried out on MSM-element in martensitic state with, e.g. tailor-made, twin variant structure by particles.

In a further example cold (e.g. ambient temperature, generally lower than the martensite transformation temperature) Shot-Peening by Water-Jet-Soda, WJS. Shot-peening of MSM-element in martensitic state with tailor-made twin variant structure by small Sodium-bicarbonate particles mixed with water and air. This embodiment is particularly suitable for sample thickness <2mm (smallest dimension).

In yet another example cold (e.g. ambient temperature, generally lower than the martensite transformation temperature) Shot-Peening by Glass-beads, CGSP. Shot-peening of MSM-element in martensitic state with tailor-made twin variant structure by small spherical glass-beads. This embodiment is particularly suitable for sample thickness of >2mm (smallest dimension).

In another embodiment, surface treatment is carried out on an MSMA-element in austenite state to activate and support desired twin variant structure in martensite state. This embodiment is also referred to as *Twin-activating surface modification.*

In yet a further example Hot (e.g. at a temperature higher than the martensite transformation temperature) Shot-Peening, HSP. Shot-peening of MSM-element in austenitic state by (small) particles. Desired twin variant structure appears upon cooling to martensitic state.

In yet another embodiment, Hot (e.g. at a temperature higher than the martensite temperature) Shot-Peening by Glass-beads, HGSP. Shot-peening of MSM-element in austenitic state by small spherical glass-beads. Desired twin variant structure appears upon cooling to martensitic state. This embodiment is particularly suitable for sample thickness >1mm.

During development of the present technology it was found that it is possible to control and optionally adjust and tailor the mechanical and magneto-mechanical properties or behavior, or both, of the whole volume of a MSMA-specimen. This can be achieved by surface layer modifications as mentioned above and as will be examined below.

An example (the group of *Functional twin-affecting surface layer modifications)* will be referred to hereinafter by the phrase "surface treatment". For demonstrating the effect of the developed methods the exact composition of the tested alloys was Ni₅₀.₂Mn₂₇.₈Ga₂₂.₀ (±0.2 atomic percent). It should, however, be pointed out that the technology is applicable to a great variety of MSM-alloys having different compositions, martensite structures and lattice structures.

To demonstrate the principle of the embodiments falling within the concept of *Twin-stabilizing surface modification* we will use a method modification called "Cold shot-peening" (CSP). Characteristic to that stabilization method is that MSMA-element is bombarded by small particles or liquid, element being during the surface treatment in low temperature phase (martensitic state) with preliminary tailor-made twin variant structure. Such a surface treatment which is applied on a MSMA specimen with preliminary tailor-made twin variant structure results in the whole volume of a MSMA-specimen into stable twin variant configuration, which corresponds by morphology to the pre-existing tailor-made twin variant structure. Since the mechanical and magneto-mechanical properties of MSMAs are tightly bounded to the particular twin variant structure (twin variant configuration) [28, 47], it follows that by such a surface treatment method it is possible to control/adjust/tailor the mechanical and magneto-mechanical properties of MSMAs. The stabilization effect and possibility to affect on the mechanical and magneto-mechanical properties will be also proved by experimental results later in this document.

Other possible *Twin-stabilizing surface modifications* are:
Shot peening, sand or ball blasting, bombardment by small particles, Laser shock peening, water peening, ultrasonic shot peeing, hammer/needle peening, or similar methods which create plastic deformation in surface layer and or difference in residual elastic stresses between surface layer and bulk of the element.

To demonstrate the principle of the embodiments of *Twin-activating surface modification* a method modification called "Hot shot-peening" (HSP) will be employed. Characteristic to that stabilization method is that MSMA-element is bombarded by small particles, element being during the surface treatment in high temperature phase (austenitic state; cubic lattice, thus no twin variants and no twin boundaries). Such a surface treatment which is applied on a MSMA specimen in austenitic state (after cooling to low temperature phase) results in the whole volume of a MSMA-specimen being brought into the desired stable twin variant configuration, which resembles the twin variant configuration and properties shown in Fig. 10c) and Fig. 9b). The stabilization effect and possibility to affect on the mechanical and magneto-mechanical properties will be also proved by experimental results later in this document.

Other possible *Twin-activating surface modifications* are:
Shot peening, sand or ball blasting, bombardment by small particles, Laser shock peening, water peening, ultrasonic shot peening, hammer/needle peening, rolling, inscribing, or any such method which creates plastic deformation in surface layer and or difference in residual elastic stresses between surface layer and bulk of the element.

All the above mentioned embodiments are preferably carried out by subjecting the surface of the element to surface treatment by directing the stream of the material at an angle which deviates by 10° at the most, preferably 5° at the most from the normal to the surface of the element.

For both basic working embodiments (*Twin-activating surface modification* and *Twin-stabilizing surface modification*) the following benefits apply which do not exist in MSMA-specimens with non-stabilized twin variant structure (untreated specimens of previous art):
1. By activation/stabilization of desired twin variant structure a relatively high twin boundary density can be obtained (at least 1-1000 twin boundaries / mm, typically 10-100 boundaries / mm). The high twin boundaries density removes the geometrical restrictions which are connected to propagation of single or few twin boundaries across long distances inside the element that is in tight air gap (see Fig. 6).
2. Twin boundaries of the stabilized twin variant structure are readily movable by an external stress or magnetic field, which movement occurs instead of nucleation of new twins with possibly undesired orientation and formation of other undesired twin variant configurations with undesired properties.
3. The twin boundaries of the stabilized twin variant structure extend through the considerable volume of the crystal and consume the major part of the specimen volume which makes nucleation of any other unwanted twin system/configuration energetically very unfavorable. Benefits 1-3 result in permanent twins (stabilized twins), that prevent nucleation of other undesired twin systems, which would otherwise lead to degradation of properties of a MSMA-element.
4. Elements with stabilized twin variant structure exhibit predictable, repeatable, proportional and smooth mechanical and magnetomechanical properties. By selecting different surface-treatment-process parameters it is possible to modify the mechanical and magnetomechanical properties of an MSMA-element. By contrast, in untreated samples (*i.e.* prior art MSMA-elements with non-stabilized twins) the mechanical and magnetomechanical behavior was unpredictable, non-repeatable and uncontrollable, see above explanations for "Single variant" and "Single twin boundary".
5. Specimens with stabilized twin variant structures with average twin boundary density over 10 TBs / 1mm has been shown to exhibit excellent fatigue properties in mechanical and magneto-mechanical actuation, while for majority of stabilized samples over 200 million cycles with strain ≈ 2-4% of the length of the element has been achieved in our tests. The non-stabilized samples typically simply stuck in air gap of actuator and it is not even possible to perform any fatigue test.
6. Twin-activated/stabilized samples work in wider range of biasing stresses than a non-treated sample. Furthermore the modified MSM elements operate even in relatively moderate magnetic fields (0.4-0.6 T).
7. The twin variant structure/configuration of the stabilized samples has been in fact shown to recover even from austenitization. That means that even if the twin-stabilized element is overheated, above T_{A}-temperature, it recovers its original (stabilized) twin variant configuration after it is cooled down below T_{M}-temperature.

The present invention activates/stabilizes the twin variant structure, so that a 3-dimensional object produced from an MSM material will exhibit the benefits given above, in particular the element will respond to mechanical stress and magnetic fields in a predictable, controllable and proportional way. Thus, the present invention will provide predictable, controllable and proportional desired mechanical and magnetomechanical properties for MSM-elements and for applications based on such twin-activated/stabilized MSM-elements.

### Procedure and physical principles of the embodiments falling under the concept of Twin-stabilizing surface modification for MSMAs

The method of shot-peening of MSMA-element, in martensitic state, with tailor-made twin variant structure consists of two steps. By element is meant here the whole MSMA-sample. In step A a desired twin variant structure is created (in martensitic state). In step B the created twin variant structure is locked/fixed by bombarding (shot-peening) the surface of the MSMA-element by bombardment media (i.e. small particles), in martensitic state. Remarkable new achievement here is that after the steps A-B the MSMA-element comprises of twin-variant structure which corresponds to the ***Tailored twin variant structure*** that was introduced into the element in step A. Surprising aspect is also that even when the treatment is done on surface, it governs the geometry and spatial distribution of appearing twin variant structure in the whole volume of a MSMA-element. From the obtained stable/repeatable twin variant structure it results that also the mechanical and magneto-mechanical properties of the material are stable/repeatable, which is clear improvement to the prior art MSMA-element manufacturing/properties [46]. Moreover, the mechanical and magneto-mechanical properties of MSMAs can beadjusted, changed, modified and tailored in the controlled way by the developed method to meet particular needs of the application.

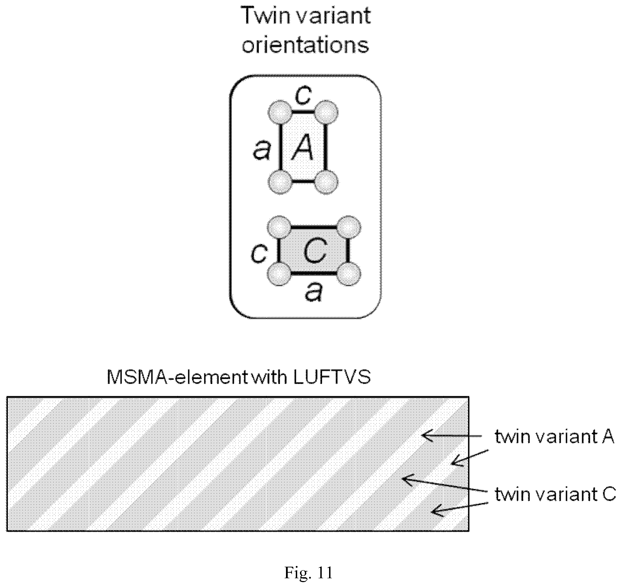

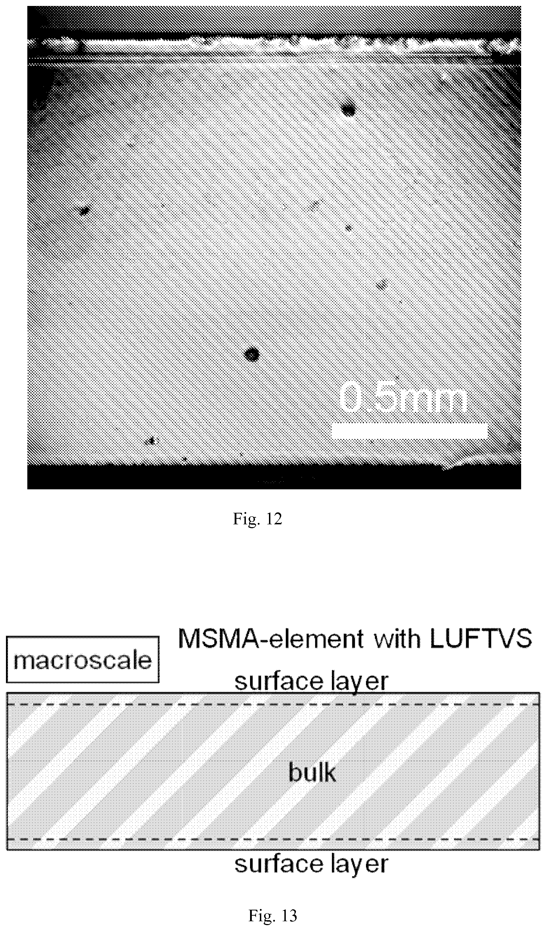

The above introduced *Twin-stabilizing surface modification method* will now be described in detailed steps. Step A consists of creating a desired twin variant structure inside the MSMA-element. This kind of twin variant structure that is created by purpose is called *Tailored twin variant structure.* One of such tailored structures is *Laminated Unidirectional Fine Twin Variant Structure* **LUFTVS** (called also *polysynthetic lamellar twins* or *dense two-variant laminate with parallel TBs*), see Fig. 11. The LUFTVS consists of lamellas of two crystallographic twin variants with two different orientations - twin variant A and twin variant C. The twin variant lamellas are separated by highly mobile twin boundaries. For optical microscope image of a LUFTVS twin variant structure in a real sample see Fig. 12.

The method of making the LUFTVS was originally demonstrated in [30, 48]. The method of making LUFTVS on Ni-Mn-Ga MSMA-elements as well as mechanical and magneto-mechanical properties of that particular structure were described/reported in [27, 25].

In [49] a conclusion was made that the LUFTVS could be the most optimal twin variant structure from the point of view of real applications such as actuators, e-harvesters, etc. Benefits of the LUFTVS are repeatable and proportional stress-strain curve and MFIS-curve, long fatigue life, increased insensitivity to actuator geometry [47]. However, a problem was noticed at that point. The LUFTVS was namely demonstrated to disappear after few or even one mechanical or magneto-mechanical actuation cycles [27]. A critical question raised at that time, how to stabilize such structure to prevent it from disappearing.

Fig. 13 shows two important regions of the MSMA-element: surface layer and the bulk (which is the inside part of the element). Generally, the surface layer comprises at the most 20 %, in particular at the most 10 %, advantageously less than 1% of the total thickness of the object to be treated. Preferably, the thickness of the surface layer is, depending on the dimensions of the object, from 1 nm to 2 mm, for example about 1 to 200 µm.

The step B contains the critical novelty part of the developed *Twin-stabilizing surface modification method* - stabilization (or fixing or locking) of the *Tailored twin variant structure,* in this example case the LUFTVS.

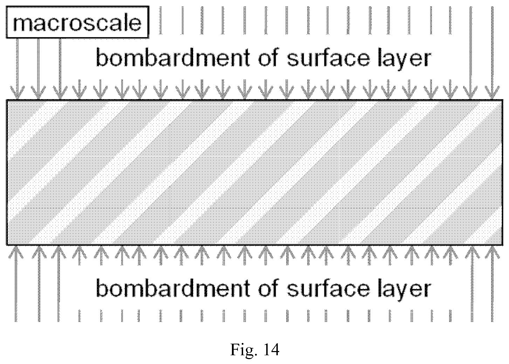

In this particular example the stabilization of the LUFTVS is realized by bombardment (shot-peening) of surface layer of MSMA-element by small particles, see Fig. 14.

Such particles can be near-round, round or irregular in shape, soft or hard but preferably round and soft. The particles material can be metal, ceramic, glass, polymer, carbon, minerals, composite materials, semiconductor, refractory or organic. The bombardment media can also be a liquid (e.g. water). The particles can be wet (e.g. with a forcible stream of water) or dry (e.g. with a forcible stream of air). An exemplary dry method is a surface bombardment with glass beads, and an exemplary wet method is surface bombardment mixture of water and an inorganic or organic powder, such as sodium bicarbonate powder. According to a particular embodiment the surface bombardment is performed with mixture of air, water and sodium bicarbonate powder.

During the surface treatment (here bombardment) the MSMA-element is in martensitic state and comprises of the tailored twin variant structure, in this case LUFTVS.

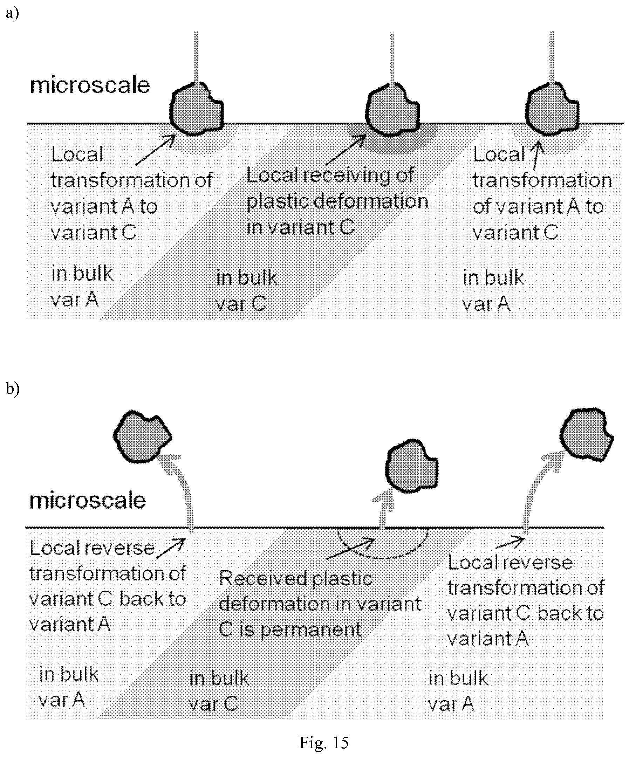

During the bombardment of surface layer by small particles, following processes are thought to be involved on microscopic scale. Kinetic energy of the particles is supposed to be absorbed by the surface layer of the MSMA-element by two different mechanisms: local plastic deformation (by dislocations) of C-variant and local transformation (by twinning) of A-variant into the C-variant, see Fig. 15).

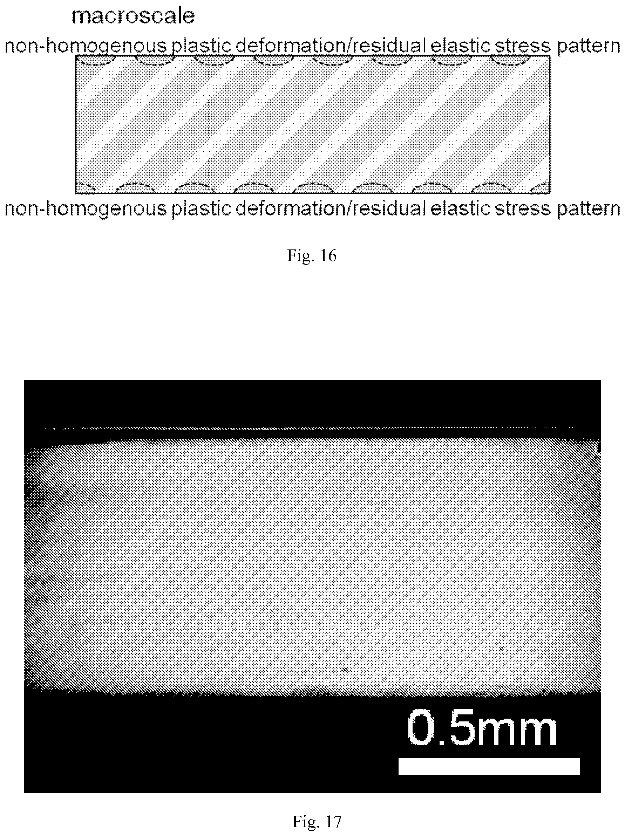

It is well known in literature that transformation from one twin variant to another by twinning is reversible, instead the plastic deformation by dislocations is irreversible [50, 51], see Fig. 15b). In materials science is also generally known that plastic deformation by dislocations creates additionally elastic stresses in deformed regions of material. Important result follows: non-homogenous plastic deformation/residual elastic stress pattern (here periodic, but can be also aperiodic) is obtained in surface layer of the MSMA-element,see Fig. 16.

Thus, as an end result of steps A-B of *Twin-stabilizing surface modification method,* we have in surface layer of MSMA-element a non-homogenous plastic deformation/residual elastic stress pattern which geometrically corresponds to the LUFTVS that was tailor-made in step A and existed in the element during the surface treatment in step B (Fig. 16).

Fig. 17 depicts the stabilized LUFTVS in surface treated.

The remarkable achievement of the *"Twin-stabilizing surface modification* " is, that the same LUFTVS nucleates and is active during the following actuation cycles even if the whole twin variant structure is erased/destroyed by forcefully bringing/deforming the MSMA-element to single variant state (by detwinning).
Repeatable and stable LUFTVS results on its turn in repeatable and stable mechanical and magneto-mechanical and fatigue properties of the MSMA-material, which was not possible to achieve by the prior art.

In the following part the assumed mechanisms will be discussed by which the non-homogenous plastic deformation/residual elastic stress pattern introduced in material during *Twin-stabilizing surface modification* nucleates and keeps active the desired *Tailored twin variant structure* (in this example LUFTVS).

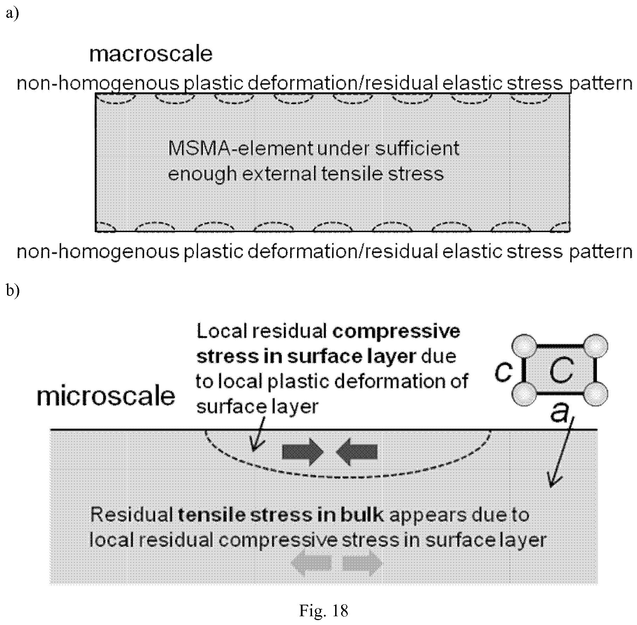

The non-homogenous plastic deformation/residual elastic stress pattern created in steps A-B is permanent and is not destroyed even when the MSMA-element is forcefully deformed by twinning to elongated single-variant or almost single-variant state, see Fig. 18a. The residual stresses originating from *Twin-stabilizing surface modification* are shown schematically on microscopic level in Fig. 18b).

The force, or more precisely stress, that brings the Ni-Mn-Ga MSMA-element after *Twin-stabilizing surface modification* to single variant (or almost single-variant) state can be external mechanical stress (app. 0.1-100MPa, in particular about 1 to 100 MPa, advantageously about 10 to 100 MPa), or external magnetic field (magnetostress up to 3MPa, for 5M Ni-Mn-Ga, and over - typically 10 MPa or less), or combinations of mechanical stress and magnetostress or any combination of thermal heat, mechanical stress, magnetostress which produces sufficient enough stress.

When the surface modified MSMA-element is released from external stresses, after being forced to elongated single-variant state, the non-homogenous plastic deformation/residual elastic stress pattern created in surface layer of MSMA-element nucleates and keeps in the volume of whole element the twin variant structure which corresponds to the twin variant structure that existed in the element during the surface treatment in step B.

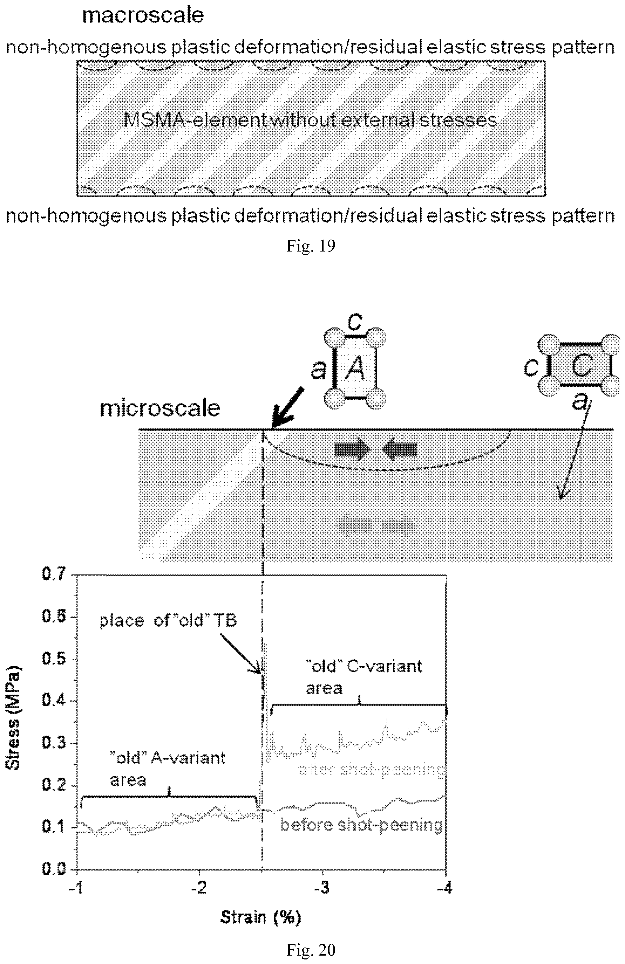

According to observations with mechanical testing device installed in optical microscope [47], the A-variant lamellas shown in Fig. 19 tend to nucleate at the border of the plastically deformed and non-deformed regions, see Fig 20. Those lamellas extend through the whole MSMA-sample. The reason for spatially selective nucleation event is thought to be due to relatively strong residual elastic stresses (shear stress or compressive stress) exactly on the place of "old" twin boundary between A-variant and C-variant that existed on that place during surface treatment (here bombardment). As an indication of relatively high elastic residual stresses on the place of "old" twin boundary is given a pair of twinning stress measurements that were done on same sample, before surface treatment and after. Extended description of that particular test is given in Appendix 1

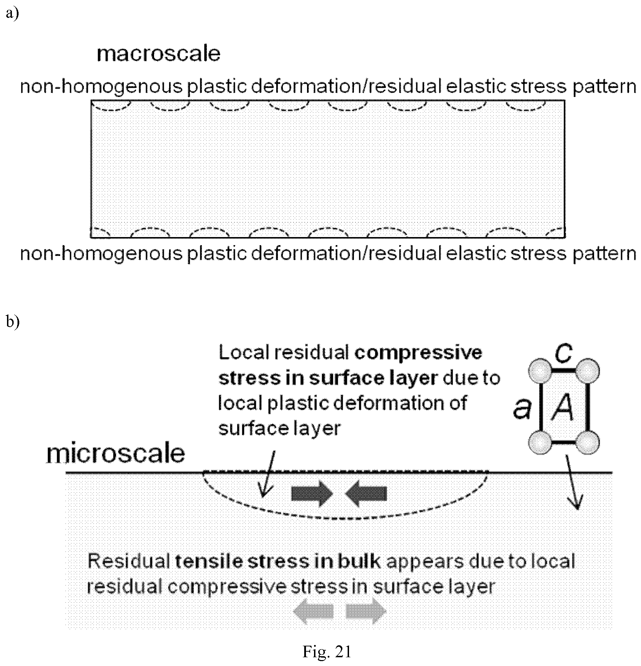

The non-homogenous plastic deformation/residual elastic stress pattern created in steps A-B is permanent and is not destroyed even when the MSMA-element is forcefully deformed by twinning to compressed single-variant or almost single-variant state, see Fig 21a. The supposed/expected residual stresses originating from *Twin-stabilizing surface modification* are shown schematically on microscopic level in Fig. 21b. The forces and stresses and their magnitudes that can bring the Ni-Mn-Ga MSMA-element after *Twin-stabilizing surface modification* to single variant (or almost single-variant) state are same as in case of elongated single-variant state in Fig. 18a-b.

When the surface modified MSMA-element is released from external stresses, after being forced to compressed single-variant state, the non-homogenous plastic deformation and residual elastic stress pattern created in surface layer of MSMA-element nucleates and keeps in the volume of whole element the twin variant structure which corresponds to the twin variant structure that existed in the element during the surface treatment in step B, see Fig. 22a.

According to observations with mechanical testing device installed in optical microscope, the C-variant lamellas shown in Fig. 22a) tend to nucleate in the middle of the plastically deformed regions, see Fig. 22b. Those lamellas extend through the whole MSMA-sample. The reason for spatially selective nucleation event of C-variant is still under investigations.

### Possible Tailored twin variant structures, including those presented above, are for example [52]

- Simple twins: Contact twins, Polysynthetic lamellar twins
- Multiple twins: Cyclic twins, sector/segment twins, Penetration twins, Mimetic twins

### Example of experimental results of applying Twin-stabilizing surface modification on the prototype of MSMAs (5M Ni-Mn-Ga)

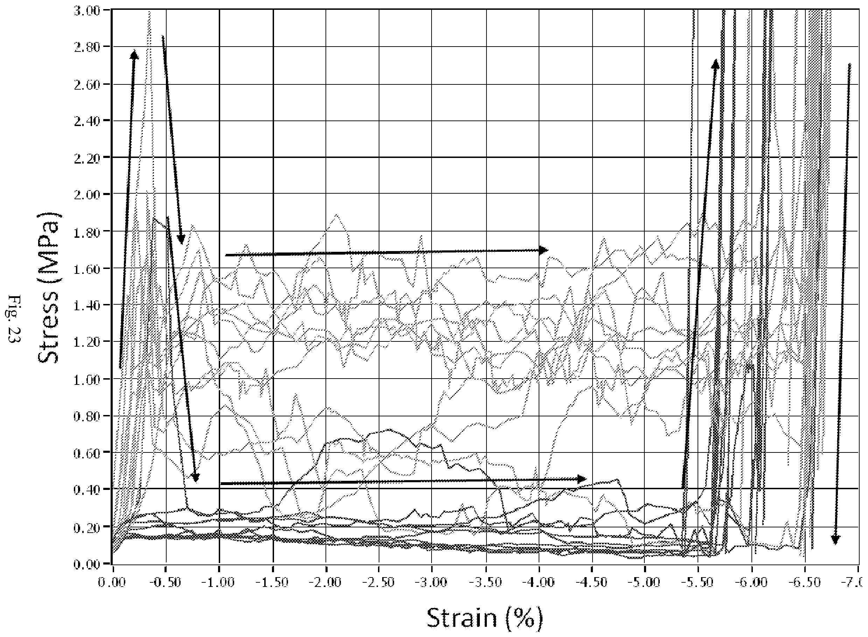

The stress-strain curves of Fig. 23 demonstrate unstable/stochastic behavior of non-stabilized MSMA-elements (5M Ni-Mn-Ga). It is very typical that the same sample deforms either under low stress level (upper curve family) or under high stress level (lower curve family) in different compression tests and it is not possible to control which way the material will choose. This kind of material is highly unpredictable and extremely difficult to use in any real-life applications due to problems discussed above.

Fig. 24 shows stress-strain curves of three different 5M Ni-Mn-Ga specimens (same 5M Ni-Mn-Ga MSM-material and same specimens as in Fig 23 but now with stabilized fine twins (LUFTVS), stabilized by the developed *Twin-stabilizing surface modification (CSP).* Here after "WJS"-treatment. Now all the samples have excellently predictable behavior and smooth proportional stress-strain curve profile which is very similar for every sample. This kind of material is almost ideal for actuators and other MSM-applications of industrial level.

Fig. 24 shows the curve family showing 10 cycles of Magnetic Field Induced Strain (MFIS) of the specimen with stabilized fine twins demonstrating excellent repeatability between cycles and proportional behavior. During MFIS the sample was under continuous bias stress of 1.2MPa to achieve two-way MSM-effect. Curves were measured on one of the samples from Fig. 23. This kind of material is well suitable for actuators and other real-life MSM-applications. The results can be compared with the stochastic and unpredictable MFIS measured on non-treated samples in Fig. 5b "Single variant".

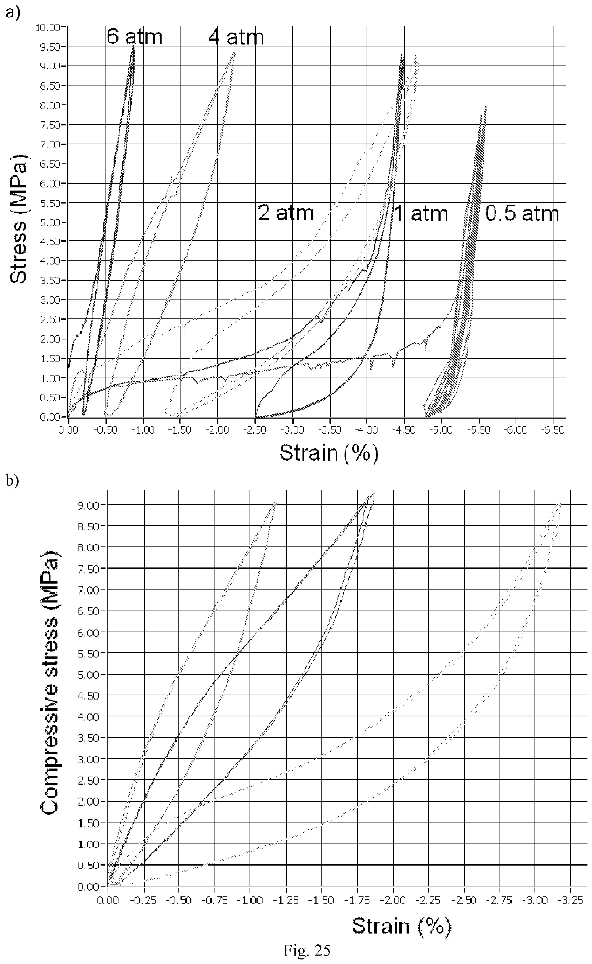

In Fig. 25 a) there is demonstrated that by varying surface bombardment parameters it is possible to modify the mechanical and magnetomechanical properties of a MSMA on a very wide range. In Fig. 25 a there is shown the effect of pressure of incoming jet of particles during bombardment process (method CSP, method modification CGSP) on the profile of stress-strain curve of the specimen. Specimen was with priory made LUFTVS during bombardment.

Fig. 25b shows the pseudoelastic parts of the stress strain curves of the same samples as in Fig. 25a . Curves demonstrate that by particular process parameters it is possible to modify previously pseudoplastic material into pseudoelastic with recoverable strain of over 3% of the length of the specimen ("Solid-state-spring material").

### Procedure and physical principles of the developed method family of Twin-activating surface modification for MSMAs

The method of shot-peening of MSMA-element, in austenitic state (Hot Shot-Peening, **HSP**), is a fast one-step-process. In HSP-process/method a plastic deformation and/or residual stresses are introduced in surface layer of a MSMA-element by bombarding (shot-peening) the surface of MSMA-element in austenite state, by small particles. Such particles can be near-round, round or irregular in shape, soft or hard but preferably round and soft. The particles material can be metal, ceramic, glass, polymer, carbon, minerals, composite materials, semiconductor or refractory, organic. The bombardment media can also be a liquid (e.g. water).

The particles can be wet (e.g. with a forcible stream of water) or dry (e.g. with a forcible stream of air). An exemplary dry method is a surface bombardment with glass beads, and an exemplary wet method is surface bombardment mixture of water and an organic or inorganic powder, such as glass, metal or ceramic balls. According to a particular embodiment the surface bombardment is performed with a forcible stream of air and glass beads.

A remarkable new achievement here is that after the HSP-treatment the MSMA-element comprises of fine twin-variant structure.

A surprising aspect is also that even when the treatment is done on surface, it governs the density (fineness) of appearing twin variant structure in the whole volume of a MSMA-element. From the obtained repeatable fine twin variant structure it results that also the mechanical and magneto-mechanical properties of the material are stable/repeatable, which is clear improvement to the prior art MSMA-element properties [27].

Moreover, the mechanical and magneto-mechanical properties of MSMAs can be modified in a controlled way by the developed method to meet particular needs of the application.

The above introduced *Twin-activating surface modification method* will now be described in detailed steps. The important point is that the HSP-treatment of MSMA-element is done in austenitic state. In Ni-Mn-Ga MSMAs the crystal structure of austenite (*γ*) is cubic, and has only one possible state - without any twin variants, see Fig. 25. In the shown austenitic state the unit cell can be characterized by one single lattice parameter *a₀*. The size of *a₀* is between the *a* and *c* parameters of the martensitic state of the material. Same definitions of the surface layer and bulk apply in HSP as in CSP.

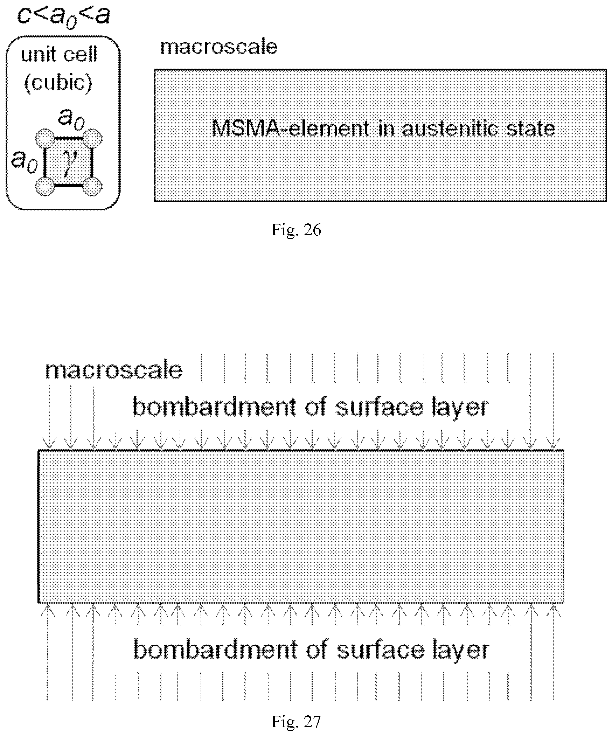

In this particular example of *Twin-activating surface modification method* the activation of the desired twin variant structure is realized by bombardment (shot-peening) of surface layer of MSMA-element by small particles, see Fig. 27.

During the *Twin-activating* surface treatment (here bombardment) the MSMA-element is in austenitic state, and thus without any twins.

During the bombardment of surface layer of element in austenitic state by small particles, following process is thought to be involved on microscopic scale. Kinetic energy of the particles is supposed to be absorbed by the surface layer of the MSMA-element by plastic deformation (by dislocations), see Fig 28 a-b. Also some small amount of appearing stress-induced-martensite is possible.

In materials science is also generally known that plastic deformation by dislocations creates additionally elastic stresses in deformed regions of material. Important result follows: (approximately)-homogenous (probably planar) plastic deformation/residual elastic stress imprint (can be done also non-homogenous by using some mask during bombardment, or by other means) is obtained in surface layer of the MSMA-element, see Fig. 29a. It is expected/assumed that the obtained plastic deformation and/or residual stress imprint is planar. The non homogenous (probably planar) plastic deformation or residual elastic stress imprint created in *Twin-activating* surface treatment is permanent. The supposed/expected residual stresses originating from *Twin-activating surface modification* are shown schematically on microscopic level in Fig. 29 b.

In the following part the assumed mechanisms will be discussed by which the homogenous (probably planar) plastic deformation/residual elastic stress imprint introduced in material during *Twin-activating surface modification* activates a desired twin variant structure (in this example *fine two-variant structure, FTVS*).

When the *Twin-activating* surface modified MSMA-element is cooled down from austenite to martensite, the homogenous (probably planar) plastic deformation/residual elastic stress imprint HPD-RESI does not disappear. The HPD-RESI created in surface layer of MSMA-element nucleates and supports the *"Fine two-variant structure"* FTVS by apparently similar mechanism that is thought to be involved in CSP, see Fig 30. Obviously the mechanism of FTVS nucleation involves the non-homogenous stress-distribution between surface layer and bulk: compressive stress of surface layer and the tensile stress in bulk that appears due to force equilibrium condition (see Fig. 29 b). By sufficient enough stress it is possible to nucleate A or C-variants also in SV or nearly SV state of MSMA-sample [26, 27, 47].

Certainly, it is well known in the literature that after transformation from austenite to martensite the appearing twin variant structure is typically fine twin variant structure, but almost without exception it consists of all the possible twin variants, which can exist in that particular crystal structure which can be over 12 variants, see [50]. The remarkable achievement is that in MSMA-element after *Twin-activating surface modification* the twin variant structure consist prevalently (usually solely) of only two twin variants, see schematic picture of activated and stabilized FTVS (Fig. 30) as well as optical microscopic image of the activated and stabilized FTVS in real MSM-sample (Fig. 31). The FTVS twin variant structure, called also "Dispersed triple-twin segments", has been shown to exhibit several advantages concerning the magneto-mechanical properties of MSMAs [47].

The MSMA-elements after *Twin-activating surface modification* can be deformed by twinning to elongated single-variant or almost single-variant state (see Fig. 32a) or deformed by twinning to compressed single-variant or almost single-variant state (see Fig. 32b). The force, or more precisely stress, that brings the Ni-Mn-Ga MSMA-element after *Twin-activating surface modification* to single variant (or almost single-variant) state can be external mechanical stress (app. 0.1-100MPa, preferably over 5MPa, in particular about 1 to 100 MPa, advantageously about 10 to 100 MPa), or external magnetic field (magnetostress up to 3MPa and over), or combination of mechanical stress and magnetostress or any combination of thermal heat, mechanical stress, and magnetostress which produces sufficient enough stress.

The second crucial feature of the MSMA-elements with *Twin-activating surface modification* is that even after deformation by twinning to compressed/elongated single-variant or almost single-variant state, after release of the external stress, the activated FTVS recovers back in the MSMA-element as in Fig. 30 and Fig. 31. According to observations with mechanical testing device installed in optical microscope, the A and C-variant lamellas shown in Fig. 30 tend to nucleate relatively evenly in the regions which were surface treated and the re-activated lamellas typically extend through the whole thickness of MSMA-sample. The FTVS has been shown to stay stable (re-activated automatically if needed) for millions of magneto-mechanical cycles in a real MSM-actuator.

Repeatable and preferably stable FTVS results in its turn in repeatable and preferably stable mechanical and magneto-mechanical properties of the MSMA-material, which could not be achieved in the art.

### Example of experimental results of applying Twin-activating surface modification on the prototype of MSMAs (5M Ni-Mn-Ga)

Fig. 33 shows stress-strain curves of one 5M Ni-Mn-Ga specimen with stabilized non-parallel fine twins (FTVS), activated and stabilized by the developed *Twin-activating surface modification (HSP).* Here after "HGSP"-treatment. The sample has excellently predictable behavior and smooth proportional stress-strain curve profile which is repeatable. Repeatability is achieved also between different samples. The morphology of FTVS twin variant structure is close to the proposed dispersed triple-twin segment array "DTTSA" in Fig. 10 c. As expected, the material exhibits similar pseudoelasticity (minor loop marked by dark arrows) as the dispersed triple-twin segment in Fig. 9a. This kind of material can be used for actuators and other MSM-applications of industrial level which benefits from pseudoelasticity.

Comparison of the magnetic shape memory materials produced according to prior art and according to present technology are shown in Fig. 23 and Fig. 24. The major observations are discussed above.

An MSM alloy, comprising a rectangularly shaped element of an Ni, Mn, Ga alloy, according to the present technology was prepared by treating the surface of the prior art MSM element with mixture of air, water and sodium bicarbonate using mini sand-blaster. The whole surface on both active surfaces was treated with maximal air intensity (inlet to unit 6 atm) and 50 % water intensity (inlet to unit 6 bar). The nozzle distance is 10 mm, jet spot size (diameter) on specimen was 2.5 mm and the process time was 60 s.

Fig. 24b shows MFIS (%) of MSM alloy specimen of the invented technology as a function of the strength of the magnetic field applied to it.

Thus, as pointed out in Fig. 4a and Fig. 23, for untreated samples strong scattering in twinning stress magnitude (uncontrollable fluctuation between 0.1 and about 1.5 MPa) and in critical switching field (see Fig 4b, 0.2-1.0 T) is also very typical. The life time of non-treated samples can be as short as few tens of cycles.

Similar results are obtained by treating corresponding MSM objects, conventional in the art, with mixtures of air, water and sodium bicarbonate or fine glass beads using a mini sandblaster.

In the working examples, the nozzle distance has been at least 1 to 2 mm from the surface to allow for a spreading of the zone of impact. The stream has been directed preferably perpendicularly or with a deviation of 5 to 10 degrees at the most from the perpendicular direction. Thus an impact angle of 75 to 115 degrees, preferably about 80 to 100 degrees, in particular 85 to 95 degrees, advantageously about 90 degrees ± 2.5 degrees, against the treated surface, is preferred.

The area treated is considerably larger when compared to the smallest dimension of the twins in the alloy. In practice, the area is at least 2 times greater, in particular at least 5 times greater, preferably at least 1000 to 10000 times greater than the smallest dimension of the twins. The smallest dimension of the twin is usually positioned perpendicular to the impact direction of the treatment (explained above). In normal practice, when objects having smallest dimensions of about 0.1 to 10 mm are processed, the area of treatment is at least 1 mm², preferably at least 5 mm², in particular at least 10 mm², advantageously at least 20 mm², for example 20 to 1000 mm².

### References cited:

1. A. Likhachev, K. Ullakko, EPJ direct Vol 1, 1999, pp 1-9
2. K. Ullakko, J.K. Huang, C. Kanter, R.C. O'Handley, V.V. Kokorin, Appl Phys Lett 69 (1996) 1966.
3. R. Tickle and R. D. James, J. Magn. Magn. Mater. 195, 627 (1999)
4. R.D. James, R. Tickle and M. Wuttig, Mat Sci Eng A 273 {275 (1999) 320.
5. A. A. Likhachev and K. Ullakko, Phys. Lett. A 275 (2000) 142.
6. S.J. Murray, M. Marioni, S.M. Allen, R.C. O'Handley, T.A. Lograsso, Appl Phys Lett 77 (2000) 886.
7. O. Heczko, A. Sozinov and K. Ullakko, IEEE Trans Magn 36 (2000) 3266.
8. A. Sozinov, A.A. Likhachev, N. Lanska, K. Ullakko, App. Phys. Lett. 80 (2002) 1746.
9. M. Chmielus, X.X. Zhang, C.Witherspoon, D.C. Dunand, P. Müllner, Nature Materials 8 (2009) 863.
10. V.A. Chernenko, M. Chmielus, P. Müllner, Appl. Phys. Lett. 95 (2009) 104103.
11. M.A. Marioni, R.C. O'Handley, S.M. Allen, Appl. Phys. Lett. 83 (2003) 3966.
12. N. Sarawate and M. Dapino, Appl. Phys. Lett. 88 (2006) 121923.
13. 1. Suorsa, E. Pagounis, and K. Ullakko Appl. Phys. Lett. 84 (2004) 4658.
14. 1. Suorsa, Performance and modeling of magnetic shape memory actuators and sensors, Doctoral Dissertation, Espoo 2005, ISBN 951-22-7644-5.
15. I. Suorsa, J. Tellinen, K. Ullakko, E. Pagounis, Journal of Applied Physics 95 (2004) 8054.
16. I. Karaman, B. Basaran, H.E. Karaca, A.I. Karsilayan, Y.I. Chumlyakov, Appl. Phys. Lett. 90 (2007) 172505.
17. I. Aaltio, K.P. Mohanchandra, O. Heczko, M. Lahelin, Y. Ge, G.P. Carman, O. Söderberg, B. Löfgren, J. Seppälä, S.-P. Hannula, Scripta Mat. 59 (2008) 550.
18. J. Tellinen, I. Suorsa, A. Jääskeläinen, I. Aaltio, K. Ullakko, \Basic Properties of Magnetic Shape Memory Actuators" in Actuator 2002 (2002) ISBN 3-933339-04-9
19. H. Schmidt, E. Quandt, \Magnetically Induced Shape Change in Solids and its Use in Actuator" in Actuator 2010 (2010) ISBN 978-3-933339-12-6
20. L. Straka, O. Heczko, H. Hänninen, Acta Mater. 56 (2008) 5492.
21. A. Likhachev, A. Sozinov, K. Ullakko, Mechanics of Materials 38 (2006) 551.
22. J.W. Christian and S. Mahajan, P. Mat. Sci. 39 (1995) 1 (p. 79{83).
23. S. Kibey, J.B. Liu, D.D. Johnson, H. Sehitoglu, Acta Mat. 55 (2007) 6843.
24. L.Straka, O.Heczko, S.-P. Hannula, Scripta Mat. 54 (2006) 1497.
25. L Straka et al 2011 J. Phys.: Conf. Ser. 303 012079 doi:10.1088/1742-6596/303/1/012079
26. I. Aaltio, O. Söderberg, Y. Ge, S.-P. Hannula, Scr. Mater. 62 (2010) 9.
27. L. Straka, N. Lanska, K. Ullakko, A. Sozinov, Twin variant structure dependent mechanical response in Ni-Mn-Ga single crystals, Appl. Phys. Lett. 96 (2010) 131903
28. M. Chmielus, K. Rolfs, R. Wimpory, W. Reimers, P. M□ullner, R. Schneider, Acta Mater. 58 (2010) 3952.
29. P. Müllner, A.H. King, Acta Mater. 58 (2010) 5242.
30. H.D. Chopra, C. Bailly, M. Wutig, Acta Mater. 44 (1996) 747
31. M.A. Marioni, Ph.D. thesis, M.I.T., Cambridge, MA (2003) http://hdl.handle.net/1721.1/7965
32. L. Straka, V. Nov_ak, M. Landa, O. Heczko, Mat. Sci. Eng. A 374 (2004) 263.
33. K. Rolfs, A. Mecklenburg, J.-M. Guldbakke, R.C. Wimpory, A. Raatz, J. Hesselbach, R. Schneider, J. Magn. Magn. Mater. 321 (2009) 1063.
34. O.Heczko, L.Straka, to be published
35. M.A. Marioni, S.M. Allen, R.C. O'Handley, Appl. Phys. Lett. 84 (2004) 4071
36. L. Straka, H. Hänninen, N. Lanska and A. Sozinov, J. Appl. Phys. 109, 063504 (2011).
37. M. Chmielus, V.A. Chernenko, W.B. Knowlton, G. Kostorz, P. Müllner, Eur. Phys. J. Special Topics 158 (2008) 79.
38. P. Müllner, G. Kostorz, Mater. Sci. Forum 583, 43 (2008).
39. M.L. Richard, Ph.D. thesis, M.I.T., Cambridge, MA (2005) http://hdl.handle.net/1721.1/33168
40. 23V. S. Boyko, R. I. Garber, A. M. Kosevich, Reversible Crystal Plasticity, (American Institute of Physics, New York, 1994).
41. S. V. Lubenets, V. I. Startsev, and L. S. Fomenko, Phys. Status Solidi A 92, 11 (1985).
42. L. Straka, N. Lanska, K. Ullakko, and A. Sozinov, Appl. Phys. Lett. 96, 131903 (2010).
43. L. Straka, H. Ha¨nninen, A. Soroka, and A. Sozinov, "Ni-Mn-Ga single crystals with very low twinning stress," accepted for publication in New J. Phys. (2011).
44. O. Heczko, and L. Straka, J. Appl. Phys. 94, 7139 (2003).
45. A. A. Likhachev, A. Sozinov, and K. Ullakko, Mater. Sci. Eng., A 378, 513 (2004).
46. L. Straka, N. Lanska, K. Ullakko, and A. Sozinov, Appl. Phys. Lett. 96, 131903 (2010).
47. Straka, L., Soroka, A., Sozinov, A., Tailored magneto-mechanical response in Ni-Mn-Ga magnetic shape memory single crystals, ACTUATOR 2010 12th International Conference on New Actuators, June 14-16, 2010, Bremen, Germany, p. 727., ISBN 978-3-933339-12-6
48. Z. S. Basinski, and J. W. Christian, Acta Metal., 2 (1954) 101
49. Sozinov, N. Lanska, A. Soroka, and L. Straka, Appl. Phys. Lett., 99 (2011) 124103
50. K. Bhattacharya, "Microstructure of Martensite - Why it forms and how it gives rise to the shape-memory effect", Oxford University Press, 2003, 288 p.,
51. K. Otsuka and C.M. Wayman, "Shape Memory Materials", Cambridge University Press, Cambridge, 1998, 284 p.
52. Th. Hahn, H. Klapper, "Twinning of crystals," in International Tables for Crystallography, Volume D, edited by A. Authier Kluwer Academic Publishers, Dordrecht, 2003, 398 p

## Claims

1. A method of modifying an element of a magnetic shape memory alloy being a composition of Ni, Mn and Ga, with an optional addition of at least one element selected from the group of Cr, Co, Cu, Fe, Ti, Al, In, Zr, Mo, Ta, W, V, Nb, Y and Pd and comprising a microstructure of twin variants and having a surface, said method comprising the step of modifying the surface layer of the element to stabilize or to activate and stabilize the twin variant structure of the element, wherein the surface modification is carried out on at least two opposite surfaces of the element, wherein said surface layer or surface region comprising 20 %, preferably less than 5 %, advantageously less than 1% at the most of the total thickness of the element at the site of the treatment and
**characterized in that**
the surface modification is carried out by surface bombardment and/or the surface treatment is carried out by Shot-Peening using Glass-beads, such as spherical glass-beads, said treatment preferably being carried out for a sample having a thickness at the treated portion of 1mm or more.

2. The method according to claim 1, wherein the mechanical and magneto-mechanical properties of the element are modified, in particular wherein the surface layer is modified in order to stabilize or to activate and stabilize the twin variant structure of the whole volume of element in order and by that modify the mechanical and magneto-mechanical properties of the whole element.

3. The method according to any of claims 1 or 2, wherein the MSM element comprises parallel lamellar twins or polysynthetic lamellar twins, in particular parallel lamellar twins or polysynthetic lamellar twins with a density of 1 to 1000 boundaries/mm, in particular about 10 - 100 boundaries/mm.

4. The method according to any of the preceding claims, wherein said surface modification is performed to at least a part of each surface, advantageously the surface modification is performed by applying any geometrical pattern to each surface, in particular said patterning is performed onto 1 to 100 %, preferably 5 to 80 %, of each surface of the element comprising the alloy.

5. The method according to any of the preceding claims, wherein the surface modification includes a surface deformation, for example a plastic deformation of the surface, or the surface modification includes the introduction of residual elastic stress into the surface layer or the surface layer modification include a combination of both deformation and introduction of residual elastic stress.

6. The method according to any of the preceding claims, wherein the surface bombardment is carried out by impacting a surface of the element with shot of soft or hard solid materials, liquid or gas or combination thereof with a force sufficient to create plastic deformation or induce residual elastic stresses in surface layer of the MSM element, for example the surface bombardment is carried out in dry state using organic or inorganic media, e.g. glass beads with forcible stream of gas, or in wet state using organic or inorganic media, e.g. sodium bicarbonate with forcible stream of gas and liquid.

7. The method according to any of the preceding claims, wherein the element comprising the alloy is in the shape of e.g. sphere, ellipsoid, round or rectangular bar, plate, wire and tube, the smallest dimension of the element being greater than 0.01 mm, preferably greater than 0.1 mm.

8. The method according to any of the preceding claims,
wherein the surface modification will be carried out in the direction of about a normal to the surface of the element at the site of the treatment, in particular the surface modification will be directed at an angle of 1 to 179 degrees, in particular about 85 to 95 degrees against the horizontal surface of the element at the site of the treatment.

## Patentansprüche

1. Verfahren zur Modifizierung eines Elements, das aus einer magnetischen Formgedächtnislegierung gebildet ist, die eine Zusammensetzung aus Ni, Mn und Ga ist, mit einer optionalen Hinzufügung von mindestens einem Element, das aus der Gruppe von Cr, Co, Cu, Fe, Ti, Al, In, Zr, Mo, Ta, W, V, Nb, Y und Pd ausgewählt ist, und das eine Zwillingsvarianten-Mikrostruktur umfasst und eine Oberfläche aufweist, wobei das Verfahren den Schritt des Modifizierens der Oberflächenschicht des Elements zur Stabilisierung oder zur Aktivierung und Stabilisierung der Zwillingsvariantenstruktur des Elements umfasst, wobei die Oberflächenmodifizierung auf mindestens zwei entgegengesetzten Oberflächen des Elements durchgeführt wird, wobei die Oberflächenschicht oder der Oberflächenbereich 20 %, bevorzugt weniger als 5 %, vorteilhaft weniger als höchstens 1 % der Gesamtdicke des Elements an der Stelle der Behandlung umfasst,
**dadurch gekennzeichnet, dass**
die Oberflächenmodifizierung durch Oberflächenbeschuss durchgeführt wird und/oder die Oberflächenbehandlung durch Kugelstrahlen unter Einsatz von Glasperlen, wie beispielsweise kugelförmigen Glasperlen, durchgeführt wird, wobei diese Behandlung bevorzugt für ein Muster durchgeführt wird, das an dem behandelten Teil eine Dicke von 1 mm oder mehr aufweist.

2. Verfahren nach Anspruch 1, wobei die mechanischen und magnetisch-mechanischen Eigenschaften des Elements modifiziert werden, wobei die Oberflächenschicht insbesondere modifiziert wird, um die Zwillingsvariantenstruktur des Gesamtvolumens des Elements zu stabilisieren oder zu aktivieren und zu stabilisieren, um so die mechanischen und magnetisch-mechanischen Eigenschaften des gesamten Elements zu modifizieren.

3. Verfahren nach Anspruch 1 oder 2, wobei das MSM-Element parallele lamellenförmige Zwillinge oder polysynthetische lamellenförmige Zwillinge umfasst, insbesondere parallele lamellenförmige Zwillinge oder polysynthetische lamellenförmige Zwillinge mit einer Dichte von 1 bis 1000 Grenzflächen/mm, insbesondere etwa 10 bis 100 Grenzflächen/mm.

4. Verfahren nach einem der vorhergehenden Ansprüche, wobei die Oberflächenmodifizierung an zumindest einem Teil jeder Oberfläche durchgeführt wird, wobei die Oberflächenmodifizierung vorteilhaft durch das Aufbringen einer beliebigen geometrischen Struktur auf jede Oberfläche durchgeführt wird, wobei die Strukturierung insbesondere auf 1% bis 100%, bevorzugt 5% bis 80% jeder Oberfläche des die Legierung umfassenden Elements durchgeführt wird.

5. Verfahren nach einem der vorhergehenden Ansprüche, wobei die Oberflächenmodifizierung eine Oberflächenverformung, beispielsweise eine plastische Verformung der Oberfläche, beinhaltet oder die Oberflächenmodifizierung die Einbringung von elastischer Eigenspannung in die Oberflächenschicht beinhaltet oder die Modifizierung der Oberflächenschicht eine Kombination aus der Verformung und der Einbringung von elastischer Eigenspannung umfasst.

6. Verfahren nach einem der vorhergehenden Ansprüche, wobei der Oberflächenbeschuss durchgeführt wird durch das Strahlen einer Oberfläche des Elements mit einem Strahlmittel aus weichen oder harten Feststoffen, Flüssigkeit oder Gas oder einer Kombination daraus mit einer Kraft, die ausreichend ist, um eine plastische Verformung zu erzeugen oder elastische Eigenspannungen in der Oberflächenschicht des MSM-Elements hervorzurufen, wobei der Oberflächenbeschuss beispielsweise im trockenen Zustand unter Einsatz von organischen oder anorganischen Medien, zum Beispiel Glasperlen mit einem Druckgasstrom, oder im feuchten Zustand unter Einsatz von organischen oder anorganischen Medien, zum Beispiel Natriumbikarbonat mit einem Druckgas- und Flüssigkeitsstrom, durchgeführt wird.

7. Verfahren nach einem der vorhergehenden Ansprüche, wobei das Element mit der Legierung beispielweise die Form einer Kugel, eines Ellipsoids, eines runden oder rechteckigen Stabs, einer Platte, eines Kabels und eines Rohrs hat, wobei das kleinste Maß des Elements größer als 0,01 mm, bevorzugt größer als 0,1 mm ist.

8. Verfahren nach einem der vorhergehenden Ansprüche, wobei die Oberflächenmodifizierung in der Richtung von ungefähr einer Normalen zu der Oberfläche des Elements an der Stelle der Behandlung durchgeführt wird, wobei die Oberflächenmodifizierung insbesondere in einem Winkel von 1 Grad bis 179 Grad, insbesondere ca. 85 Grad bis 95 Grad, gegen die horizontale Oberfläche des Elements an der Stelle der Behandlung gerichtet wird.

## Revendications

1. Procédé de modification d'un élément d'un alliage à mémoire de forme magnétique étant une composition de Ni, Mn et Ga, avec un ajout facultatif d'au moins un élément choisi parmi le groupe de Cr, Co, Cu, Fe, Ti, Al, In, Zr, Mo, Ta, W, V, Nb, Y et Pd et comprenant une microstructure de variantes de macle et ayant une surface, ledit procédé comprenant l'étape de modification de la couche de surface de l'élément afin de stabiliser ou afin d'activer et stabiliser la structure de variantes de macle de l'élément, la modification de surface étant réalisée sur au moins deux surfaces opposées de l'élément, la couche de surface ou zone de surface comprenant 20 %, de préférence moins de 5 %, plus préférentiellement moins de 1 % au plus de l'épaisseur totale de l'élément sur le site du traitement et
**caractérisé en ce que**
la modification de surface est réalisée par bombardement de surface et/ou le traitement de surface est réalisé par grenaillage en utilisant des billes de verre, par exemple des billes de verre sphériques, ledit traitement étant de préférence réalisé pour un échantillon qui a une épaisseur de 1 mm ou plus à la partie traitée.

2. Procédé selon la revendication 1, dans lequel les propriétés mécaniques et magnéto-mécaniques de l'élément sont modifiées, la couche de surface étant modifiée notamment afin de stabiliser ou afin d'activer et stabiliser la structure de variantes de macle du volume total de l'élément afin de modifier ainsi les propriétés mécaniques et magnéto-mécaniques de l'élément entier.

3. Procédé selon la revendication 1 ou la revendication 2, dans lequel l'élément MSM comprend des macles lamellaires parallèles ou des macles lamellaires polysynthétiques, notamment des macles lamellaires parallèles ou des macles lamellaires polysynthétiques qui ont une densité de 1 à 1000 joints/mm, notamment approximativement 10 à 100 joints/mm.

4. Procédé selon l'une quelconque des revendications précédentes, dans lequel la modification de surface est appliquée à au moins une partie de chaque surface, la modification de surface étant réalisée avantageusement par l'application d'une structure géométrique à chaque surface, ladite structuration étant réalisée notamment sur 1 % à 100 %, de préférence 5 % à 80 %, de chaque surface de l'élément comprenant l'alliage.

5. Procédé selon l'une quelconque des revendications précédentes, dans lequel la modification de surface comprend une déformation de surface, par exemple une déformation plastique de la surface, ou la modification de surface comprend l'introduction de la contrainte résiduelle élastique dans la couche de surface ou la modification de couche de surface comprend une combinaison de la déformation et l'introduction de la contrainte résiduelle élastique.

6. Procédé selon l'une quelconque des revendications précédentes, dans lequel le bombardement de surface est effectué par la projection de la grenaille en matériaux solides doux ou durs, du liquide ou du gaz ou une combinaison de ceux-ci sur une surface de l'élément à une force suffisante pour créer une déformation plastique ou pour induire des contraintes résiduelles élastiques dans la couche de surface de l'élément MSM, le bombardement de surface étant effectué par exemple à l'état sec en utilisant des milieux organiques ou inorganiques, par exemple des billes de verre au moyen d'un jet de gaz forcé, ou à l'état mouillé en utilisant des milieux organiques ou inorganiques, par exemple bicarbonate de sodium au moyen d'un jet de gaz et de liquide forcé.

7. Procédé selon l'une quelconque des revendications précédentes, dans lequel l'élément comprenant l'alliage a la forme d'une sphère, d'un ellipsoïde, d'une barre ronde ou rectangulaire, d'une plaque, d'un fil et d'un tube, la plus petite dimension de l'élément étant plus grande que 0,01 mm, de préférence plus grande que 0,1 mm.

8. Procédé selon l'une quelconque des revendications précédentes, dans lequel la modification de surface est effectuée dans la direction d'une normale approximative par rapport à la surface de l'élément sur le site du traitement, la modification de surface étant orientée notamment à un angle de 1 degré à 179 degrés, notamment approximativement 85 degrés à 95 degrés sur la surface horizontale de l'élément sur le site du traitement.
